(19) Europäisches Patentamt
European Patent Office
Office européen des brevets

(11) EP 4 709 119 A2

(12) # EUROPEAN PATENT APPLICATION

published in accordance with Art. 153(4) EPC

(43) Date of publication:
**11.03.2026 Bulletin 2026/11**

(21) Application number: **24758434.5**

(22) Date of filing: **12.04.2024**

(51) International Patent Classification (IPC):
***H10K 59/80*** $^{(2023.01)}$ ***H10K 59/35*** $^{(2023.01)}$
***H10K 71/10*** $^{(2023.01)}$

(52) Cooperative Patent Classification (CPC):
**H10K 59/35; H10K 59/80; H10K 71/10**

(86) International application number:
**PCT/KR2024/004920**

(87) International publication number:
**WO 2024/228491 (07.11.2024 Gazette 2024/45)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **04.05.2023 KR 20230058628**
**09.04.2024 KR 20240048210**

(71) Applicants:
- **Yas Co., Ltd.**
  **Paju-si, Gyeonggi-do 10857 (KR)**
- **Ahn, Byungchul**
  **Seoul 06574 (KR)**

(72) Inventor: **AHN, Byungchul**
**Seoul 06574 (KR)**

(74) Representative: **Epping - Hermann - Fischer Patentanwaltsgesellschaft mbH**
**Schloßschmidstraße 5**
**80639 München (DE)**

(54) **ORGANIC LIGHT-EMITTING DISPLAY DEVICE**

(57) An organic light-emitting display device, comprising: a first three-dimensional structure on a substrate; a second three-dimensional structure spaced apart from the first three-dimensional structure with a separation region therebetween along a first direction on the substrate; a first subpixel on one side surface of the first three-dimensional structure; a second subpixel on one side surface of the second three-dimensional structure; and a third subpixel on the separation region. The first subpixel can comprise a first organic light-emitting device, the second subpixel can comprise a second organic light-emitting device, and the third subpixel can comprise a third organic light-emitting element. The first three-dimensional structure and the second three-dimensional structure can each have a structure that is separated into at least a unit of one or more pixel along a second direction or a long structure as one piece, and the one side surface of the first three-dimensional structure and the one side surface of the second three-dimensional structure can each be perpendicular to the substrate.

FIG. 4

A
A'
130g
130r
130T
130-1
130-1b
θa1
130-2a
θa2
130-2b
130-1a
140g
140b
105
130b
130-2
140'g
Z
Y
X

EP 4 709 119 A2

## Description

## BACKGROUND OF THE DISCLOSURE

### Field

The embodiment relates to an organic light-emitting display device.

### Discussion of the Related Art

Recently, as society has entered a full-fledged information age, there is growing interest in information displays that process and display large amounts of information. In addition, the display field has been developing rapidly as the demand for using portable information media has increased. In response to this, a variety of lightweight and thin flat panel display devices are attracting attention.

Among these flat display devices, an organic light-emitting display device (OLED, hereinafter referred to as OLED) is attracting attention. The OLED is being actively developed to be used as a display device for a head mounted display (HMD) mounted close to the human eye. The HMD can be worn in the form of a helmet or glasses to implement virtual reality (VR) or augmented reality (AR).

The HMD is equipped with a high-resolution and small-sized OLED. The high-resolution and small-sized OLED has organic light-emitting elements disposed on a driving circuit formed using a wafer-based semiconductor process. Meanwhile, a glasses-shaped HMD requires a brighter and clearer screen having a very small screen size. To this end, the amount of light from the organic light-emitting element and the light extraction efficiency must be maximized. In addition, light leakage between pixels must be suppressed to improve image quality. Light extraction efficiency improvement technology that can be applied to ultra-high resolution is expected to be widely applied to the large-screen display industry such as mobile devices and IT devices.

Meanwhile, conventionally, a fine metal mask (FMM) is used as a pattern mask for deposition to form an organic light-emitting layer constituting an organic light-emitting element by depositing it for each subpixel.

However, when manufacturing high-precision (e.g., 500 PPI or higher) display device or large-area (e.g., 8$^{th}$ generation or higher) display device, it is quite difficult to form an organic light-emitting layer for each subpixel using FMM. Additionally, when using FMM, there is a limit to further increasing high-precision. Additionally, when using FMM, there is a problem of lower yield and increased manufacturing cost. In addition, when using FMM, there is a problem that product lifespan is reduced due to difficulty in optimizing deposition.

Meanwhile, recently, as the resolution of displays has increased, the pixel resolution (ppi) has also increased, and the gap between pixels (or subpixels) is becoming increasingly narrow. In addition, as the efficiency of light-emitting materials for organic light-emitting elements increases, high luminance can be produced with low current and voltage, which has the advantage of lowering power consumption. However, as the efficiency of light-emitting materials for organic light-emitting elements increases, light emission becomes possible even with a small amount of current, and thus light can be emitted by a small amount of current leaking from one pixel (or subpixel) to another adjacent pixel (or subpixel). As a result, a phenomenon occurs in which adjacent pixels (or subpixels) that should not emit light also emit light. This leakage of current is called lateral current leakage.

When leakage light occurs due to lateral current leakage, problems such as color mixing and color coordinate changes occur. Additionally, when leakage light occurs in a low luminance area, the black luminance can be increased.

To suppress leakage light, there are ways to lower the efficiency of the light-emitting material or lower the resolution of the display device. However, as demand for low-power, high-resolution products is increasing recently, it is not desirable to solve the problem of leakage light caused by lateral current leakage by lowering the efficiency of the light-emitting material or the resolution of the display device. Therefore, there is a need for a technology that can suppress leakage light caused by lateral current leakage in a display device using a high-efficiency light-emitting material without lowering the resolution.

## SUMMARY OF THE DISCLOSURE

An object of the embodiment is to solve the foregoing and other problems.

Another object of the embodiment is to provide a high-precision and high-resolution organic light-emitting display device.

Another object of the embodiment is to provide an organic light-emitting display device that does not use FMM.

Another object of the embodiment is to provide an organic light-emitting display device that can prevent lateral current leakage between pixels (or subpixels).

The technical problems of the embodiments are not limited to those described in this item and include those that can be understood through the description of the invention.

According to one aspect of the embodiment to achieve the above or other objects, an organic light-emitting display device, comprising: a first three-dimensional structure on a substrate; a second three-dimensional structure spaced apart from the first three-dimensional structure with a separation region therebetween along a first direction on the substrate; a first subpixel on one side surface of the first three-dimensional structure; a second subpixel on one side surface of the second three-dimensional structure; and a third subpixel on the separation region, wherein the first subpixel comprises a first organic light-emitting device, wherein the second subpixel comprises a second organic light-emitting device, wherein the third subpixel comprises a third organic light-emitting element, wherein the first three-dimensional structure and the second three-dimensional structure each have a structure that is separated into at least a unit of one or more pixel along a second direction or a long structure as one piece, and wherein the one side surface of the first three-dimensional structure and the one side surface of the second three-dimensional structure are each perpendicular to the substrate.

The one side surface of the first three-dimensional structure can have a first average wall angle with respect to the substrate, the one side surface of the second three-dimensional structure can have a second average wall angle with respect to the substrate, and the first average wall angle and the second average wall angle can be the same.

The organic light-emitting display device can comprise another second subpixel on the other side surface of the first three-dimensional structure; and another first subpixel on the other side surface of the second three-dimensional structure.

One or two or more first organic light-emitting devices can be provided on the one side surface of the first three-dimensional structure along the second direction, one or two or more second organic light-emitting devices can be provided on the one side surface of the second three-dimensional structure along the second direction, and one or two third organic light-emitting devices can be provided on the third auxiliary electrode along the second direction.

The organic light-emitting display device can further comprise: a first anode separation structure along the perimeter of the first three-dimensional structure; and a second anode separation structure along the perimeter of the second three-dimensional structure.

The first organic light-emitting device, the second organic light-emitting device, and the third organic light-emitting device can comprise a charge generation layer in common, the first anode separation structure can disconnect the charge generation layer between the first subpixel and the third subpixel, and the second anode separation structure can disconnect the charge generation layer between the second subpixel and the third subpixel.

The organic light-emitting display device can further comprise: a first insulating layer on the first organic light-emitting device, the second organic light-emitting device, and the third organic light-emitting device; a second insulating layer on the first insulating layer between the first three-dimensional structure and the second three-dimensional structure; and a third insulating layer on the second insulating layer.

The third insulating layer can be in contact with an upper surface of the first three-dimensional structure and an upper surface of the second three-dimensional structure.

The second insulating layer can comprise light scattering particles.

The organic light-emitting display device can further comprise: a lens structure on the third insulating layer between the first three-dimensional structure and the second three-dimensional structure.

The effects of the organic light-emitting display device according to the embodiment are described as follows.

According to at least one of the embodiments, subpixels can be disposed on the three-dimensional structure. Accordingly, the light-emitting area of each subpixel is maintained or expanded, but the occupied area is reduced, so that a high-precision and high-resolution display can be implemented.

According to at least one of the embodiments, by increasing the inclination angle of the side surface of the three-dimensional structure or having a vertical surface, the blue organic light-emitting layer in the blue common structure may not be formed on the side surface of the three-dimensional structure or can be formed with a very thin thickness. Accordingly, the blue organic light-emitting layer does not affect the light emission of each subpixel, and defects due to color purity deterioration or color unevenness can be prevented.

According to at least one of the embodiments, the anode electrode of each subpixel can be naturally disconnected (or separated) by the anode separation structure. Accordingly, a patterning process to separate the anode electrode for each subpixel is not required, thereby preventing defects due to the patterning process, simplifying the process, and reducing costs.

According to at least one of the embodiments, the charge generation layer can be disconnected (or separated) for each subpixel by the anode separation structure. Accordingly, lateral current leakage between each subpixel can be prevented.

Additional scope of applicability of the embodiments will become apparent from the detailed description that follows. However, since various changes and modifications within the spirit and scope of the embodiments can be clearly understood by those skilled in the art, the detailed description and specific embodiments, such as preferred embodiments, should be understood as being given by way of example only.

## BRIEF DESCRIPTION OF THE DRAWINGS

FIG. 1 is a plan view schematically showing an organic light-emitting display device according to an embodiment.

FIG. 2 is a perspective view schematically showing an organic light-emitting display device according to an embodiment as a first example.

FIG. 3 is a perspective view schematically showing an organic light-emitting display device according to an embodiment as a second example.

FIG. 4 is a perspective view schematically showing an organic light-emitting display device according to an embodiment as a third example.

FIG. 5 is a cross-sectional view showing an organic light-emitting display device according to a first embodiment.

FIG. 6 is a cross-sectional view showing an organic light-emitting display device according to a second embodiment.

FIG. 7 is a cross-sectional view showing an organic light-emitting display device according to a third embodiment.

FIG. 8 is a cross-sectional view showing an organic light-emitting display device according to a fourth embodiment.

FIG. 9A is a cross-sectional view showing the stacked structure of each organic light-emitting element according to a first embodiment.

FIG. 9B is a cross-sectional view showing the stacked structure of each organic light-emitting element according to a second embodiment.

FIG. 10A shows a deposition system according to an embodiment.

FIG. 10B shows the deposition of a blue organic light-emitting layer, a red organic light-emitting layer, and a green organic light-emitting layer on a substrate.

FIG. 10C is a diagram explaining a self-aligned deposition (SAD) method of an embodiment.

FIG. 11 is a flowchart showing a method of manufacturing an organic light-emitting display device according to a first embodiment.

FIGS. 12A to 12N are cross-sectional views showing a method of manufacturing an organic light-emitting display device according to a first embodiment.

FIG. 13 is a flowchart showing a method of manufacturing an organic light-emitting display device according to a second embodiment.

FIGS. 14A to 14D are cross-sectional views showing a method of manufacturing an organic light-emitting display device according to a second embodiment.

FIG. 15 is a detailed cross-sectional view of area X in FIG. 7.

FIG. 16 is a flowchart showing a method of manufacturing an organic light-emitting display device according to a third embodiment.

FIGS. 17A to 17G are cross-sectional views showing a method of manufacturing an organic light-emitting display device according to a third embodiment.

FIG. 18 shows the height and depth of the undercut structure in an anode separation structure according to an embodiment.

FIG. 19 is a cross-sectional view showing an organic light-emitting display device according to a fifth embodiment.

FIG. 20 is a cross-sectional view showing an organic light-emitting display device according to a sixth embodiment.

FIG. 21A is a cross-sectional view of a schematic panel design of an AR product.

FIG. 21B is a design data sheet for the panel design of FIG. 21A.

FIG. 22 is a plan view of a schematic panel design of an AR product.

The sizes, shapes, dimensions, etc. of elements shown in the drawings can differ from actual ones. In addition, even if the same elements are shown in different sizes, shapes, dimensions, etc. between the drawings, this is only an example on the drawing, and the same elements have the same sizes, shapes, dimensions, etc. between the drawings.

## DETAILED DESCRIPTION OF EMBODIMENTS

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there can be directly on the other element or be other intermediate elements therebetween.

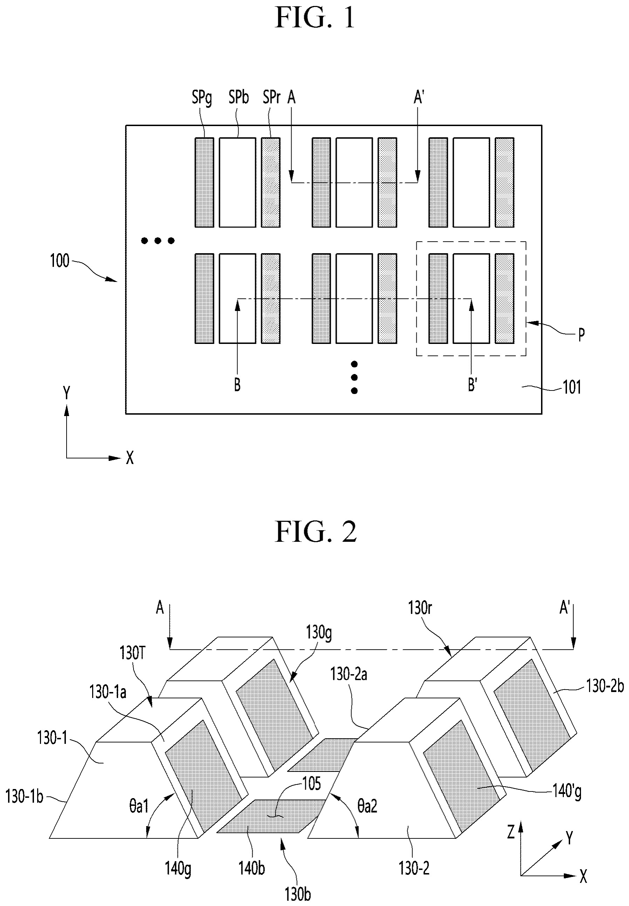

FIG. 1 is a plan view schematically showing an organic light-emitting display device according to an embodiment.

The organic light-emitting display device 100 according to the embodiment can have a top emission type or a bottom emission type. A top emission organic light-emitting display device can display an image by emitting light in an upward direction. A bottom emission organic light-emitting display device can display an image by emitting light in a downward direction.

Referring to FIG. 1, an organic light-emitting display device 100 according to an embodiment can comprise a plurality of pixels P disposed on a substrate 101.

The substrate 101 can be divided into a display area and a non-display area. A plurality of pixels P can be disposed on the display area. A driving device such as a gate driver, a data driver, etc. can be disposed in the non-display area, but is not limited thereto. A plurality of pixels P can be disposed in a matrix. A plurality of pixels P can be disposed along a first direction X. A plurality of pixels P can be disposed along a second direction Y.

Each pixel P can comprise a plurality of subpixels SPg, SPr, and SPb. The plurality of subpixels SPg, SPr, and SPb can comprise subpixels of at least three different colors.

As a first example, the plurality of subpixels SPg, SPr, and SPb can be separated in units of pixels P or row lines along the second direction Y. For example, the green subpixel SPg can be separated in units of pixels P or row lines along the second direction Y, the red subpixel SPr is separated in units of pixels P or row lines along the second direction Y, and the blue subpixel SPr can be separated in units of pixels P or row lines along the second direction Y.

As a second example, a plurality of subpixels SPg, SPr, and SPb can be disposed in a stripe shape along the second direction Y. In a stripe-shaped structure, a plurality of subpixels SPg, SPr, and SPb can be sequentially disposed without being separated along the second direction Y, respectively. For example, the green subpixel SPg can be continuously disposed along the second direction Y, the red subpixel SPr can be continuously disposed along the second direction Y, and the blue subpixel SPr can be continuously disposed along the second direction Y.

Meanwhile, in the first and second examples, the green subpixel SPg, the red subpixel SPr, and the blue subpixel SPb can be alternately disposed in column lines along the first direction X. That is, in an embodiment, the green subpixel SPg, the red subpixel SPr, and the blue subpixel SPb having different colors can be disposed in a side-by-side structure along the first direction X. In the side-by-side structure, it is very important to implement high precision and high resolution without reducing the light-emitting area of each of the plurality of subpixels SPg, SPr, and SPb.

The green subpixel SPg can be named the first subpixel, the red subpixel SPr can be named the second subpixel, and the blue subpixel SPb can be named the third subpixel.

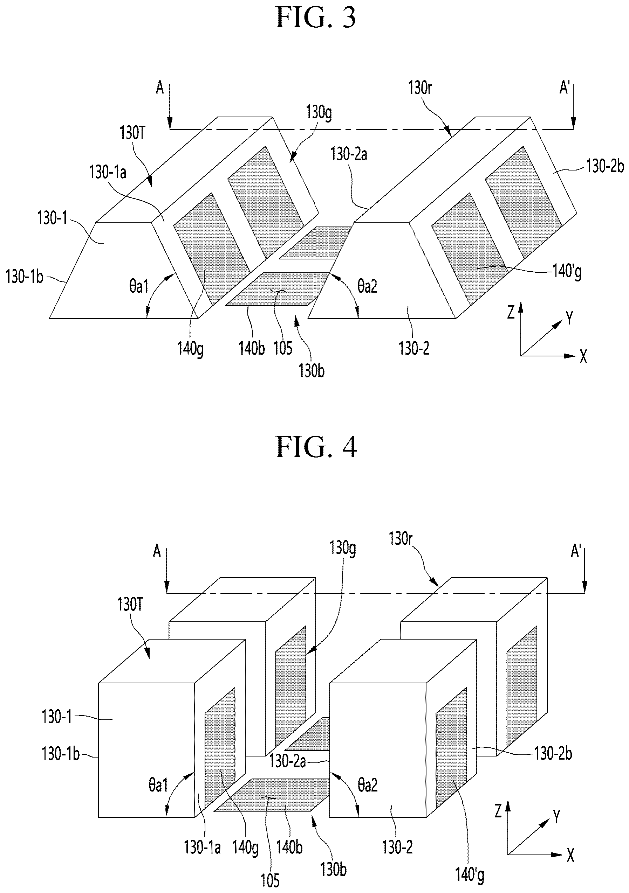

FIGS. 2 and 4 show organic light-emitting display devices on various three-dimensional structures 130-1 and 130-2. That is, FIG. 2 is a perspective view schematically showing an organic light-emitting display device according to an embodiment as a first example, FIG. 3 is a perspective view schematically showing an organic light-emitting display device according to an embodiment as a second example, and FIG. 4 is a perspective view schematically showing an organic light-emitting display device according to an embodiment as a third example. FIGS. 2 to 4 are cross-sectional views taken along line A-A' in FIG. 1.

For convenience of explanation, two three-dimensional structures 130-1 and 130-2 are shown, but a plurality of three-dimensional structures can be disposed on the substrate 100.

As shown in FIGS. 1 to 4, the organic light-emitting display device 100 according to the embodiment can comprise three-dimensional structures 130-1 and 130-2. The three-dimensional structures 130-1 and 130-2 can have at least two side surfaces 130-1a, 130-1b, 130-2a, and 130-2b, and at least two subpixels SPg and SPr can be disposed on at least two side surfaces 130-1a, 130-1b, 130-2a and 130-2b. With this structure, high-precision and high-resolution implementation is possible without reducing the light-emitting area of each subpixel SPg and SPr.

In the drawing, the side surfaces 130-1a, 130-1b, 130-2a, and 130-2b have straight surfaces, but alternatively, they can have curved surfaces or uneven surfaces. The side surfaces 130-1a, 130-1b, 130-2a and 130-2b can be referred to as wall surfaces. The side surfaces 130-1a, 130-1b, 130-2a, and 130-2b and the wall surface can be used interchangeably.

The three-dimensional structures 130-1 and 130-2 can have a dot structure. The three-dimensional structures 130-1 and 130-2 can be disposed as a matrix along the first direction X and the second direction Y. The three-dimensional structures 130-1 and 130-2 can be separated in units of pixels P or column lines along the first direction X. As shown in FIGS. 2 and 4, the three-dimensional structures 130-1 and 130-2 can be separated in units of pixels P or row lines along the second direction Y. As shown in FIG. 3, the three-dimensional structures 130-1 and 130-2 can be separated in units of two or more pixels P or row lines along the second direction Y.

Although not shown, the three-dimensional structures 130-1 and 130-2 can be continuously disposed in a stripe shape along the second direction Y. That is, the three-dimensional structures 130-1 and 130-2 can be disposed long as one piece without being separated along the second direction Y.

The side surfaces 130-1a, 130-1b, 130-2a, and 130-2b of the three-dimensional structures 130-1 and 130-2 can have inclined surfaces (FIGS. 2 and 3) or vertical surfaces (FIG. 4). Although not shown, the side surfaces 130-1a, 130-1b, 130-2a, and 130-2b of the three-dimensional structures 130-1 and 130-2 can be separated in units of two or more pixels P or row lines along the second direction Y, and can also have vertical surfaces.

A plurality of subpixels SPg, SPr, and SPb can be driven sequentially or alternately for at least one row line by a scan signal. For example, a first row line, a third row line, a second row line, and a fourth row line can be driven alternately in that order. Through this alternating driving, leakage current in the second direction Y can be reduced.

Since the three-dimensional structures 130-1 and 130-2 are separated into unit of one pixel P or units of two or more pixels P along the second direction Y, the patterning process of the anode electrode is easy, and leakage current between pixel P or subpixel SPg, SPr and SPb along the second direction Y can be reduced.

Depending on the resolution of the organic light-emitting display device 100, the height or width of the three-dimensional structures 130-1 and 130-2 can be determined, and the manufacturing method of the three-dimensional structures 130-1 and 130-2 can also be determined.

The first three-dimensional structure 130-1 and the second three-dimensional structure 130-2 can be provided on the substrate 101. The first three-dimensional structure 130-1 and the second three-dimensional structure 130-2 can be spaced apart with a separation region 105 therebetween. The second three-dimensional structure 130-2 can be spaced apart from the first three-dimensional structure 130-1 with a separation region 105 along the first direction X.

In this case, one pixel P can be defined using the first side surface 130-1a of the first three-dimensional structure 130-1, the first side surface 130-2a of the second three-dimensional structure 130-2, and the separation region 105. The first side surface 130-1a of the first three-dimensional structure 130-1 and the first side surface 130-2a of the second three-dimensional structure 130-2 can be positioned to face each other with the separation region 105 interposed therebetween. The first side surface 130-1a of the first three-dimensional structure 130-1 can contact one side of the separation region 105, and the first side surface 130-2a of the second three-dimensional structure 130-2 can contact the other side of the separation region 105.

For example, the green subpixel SPg can be defined on the first side surface 130-1a of the first three-dimensional structure 130-1, the red subpixel SPr can be defined on the first side surface 130-2a of the second three-dimensional structure 30-2, and the blue subpixel SPb can be defined on the separation region 105 between the first three-dimensional structure 130-1 and the second three-dimensional structure 130-2. One pixel P can be composed of the green subpixel SPg, the red subpixel SPr, and the blue subpixel SPb. Accordingly, by providing a plurality of three-dimensional structures on the substrate 101, a plurality of pixels can be defined.

The green organic light-emitting element 140g can be disposed in the green subpixel SPg, the red organic light-emitting element 140r can be disposed in the red subpixel 140r, and the blue organic light-emitting element 140b can be disposed in the blue subpixel SPb. The green organic light-emitting element 140g can be named the first organic light-emitting element, the red organic light-emitting element 140r can be named the second organic light-emitting element, and the blue organic light-emitting element 140b can be named the third organic light-emitting element.

Another red organic light-emitting element 140'r can be disposed in the red subpixel SPr on the second side surface 130-1b of the first three-dimensional structure 130-1, and another green organic light-emitting element 140'g can be disposed in the green subpixel SPg on the second side surface 130-2b of the second three-dimensional structure 130-2.

Accordingly, the red subpixel SPr, the green subpixel SPg, the blue subpixel SPb, the red subpixel SPr, and the green subpixel SPg can be disposed in the order along the first direction X. Another red organic light-emitting element 140'r, the green organic light-emitting element 140g, the blue organic light-emitting element 140b, the red organic light-emitting element 140r, and another green organic light-emitting element 140'g can be disposed in the order along the first direction X.

The average wall angles θa1 and θa2 can be obtained from the side surfaces 130-1a, 130-1b, 130-2a, and 130-2b of the three-dimensional structures 130-1 and 130-2. For example, the average wall angles θa1 and θa2 can be angles that extend from each of the upper and lower ends of the anode electrode and contact the surface of the separation region 105 of the substrate 101 at the upper surface 130T of the three-dimensional structures 130-1 and 130-2. When the side surfaces 130-1a, 130-1b, 130-2a, and 130-2b of the three-dimensional structures 130-1 and 130-2 have round faces, the average wall angles θa1 and θa2 can be obtained using linear extrapolation method.

As an example, depending on the sizes of the average wall angles θa1 and θa2, the three-dimensional structures 130-1 and 130-2 can have rhombus pillars (FIGS. 2 and 3) or square pillars (FIG. 4) when viewed from the side. That is, the inner diameter or area of the three-dimensional structures 130-1 and 130-2 can decrease as it goes to the top. In three-dimensional structures 130-1 and 130-2 having rhombic pillars (FIGS. 2 and 3) or square pillars (FIG. 4), the average wall angles θa1 and θa2 can be greater than 60 degrees and less than 90 degrees.

As another example, the average wall angles θa1 and θa2 can be perpendicular to the substrate 101. That is, the average wall angles θa1 and θa2 can be 90 degrees with respect to the substrate 101.

As another example, the three-dimensional structures 130-1 and 130-2 can have a reverse taper shape in which the inner diameter or area increases as it goes to the top. In this case, the average wall angles θa1 and θa2 can be 90 degrees or more with respect to the substrate 101.

Meanwhile, when the average wall angle θa is vertical, i.e., closer to 90 degrees, it is advantageous for high resolution. The average wall angle θa can be an angle relative to the ground or substrate 101. In a blue common structure, the blue organic light-emitting layer 142B can be commonly disposed in the green subpixel SPg, the red subpixel SPr, and the blue subpixel SPb. When the average wall angle θa is vertical, i.e., closer to 90 degrees, the thickness of the blue organic light-emitting layer 142B commonly disposed in the green subpixel SPg and the red subpixel SPr can be minimized, and thus defects due to color purity deterioration or color unevenness can be minimized.

Meanwhile, as shown in FIG. 3, the three-dimensional structures 130-1 and 130-2 can be separated in units of two or more pixels P or row lines along the second direction Y. In this case, two or more green organic light-emitting elements 140g can be provided on the first side surface 130-1a of the first three-dimensional structure 130-1 along the second direction Y. Two or more red organic light-emitting elements 140r can be provided on the first side surface 130-2a of the second three-dimensional structure 130-2 along the second direction Y. Two or more blue organic light-emitting elements 140b can be provided on the separation region 105 along the second direction Y.

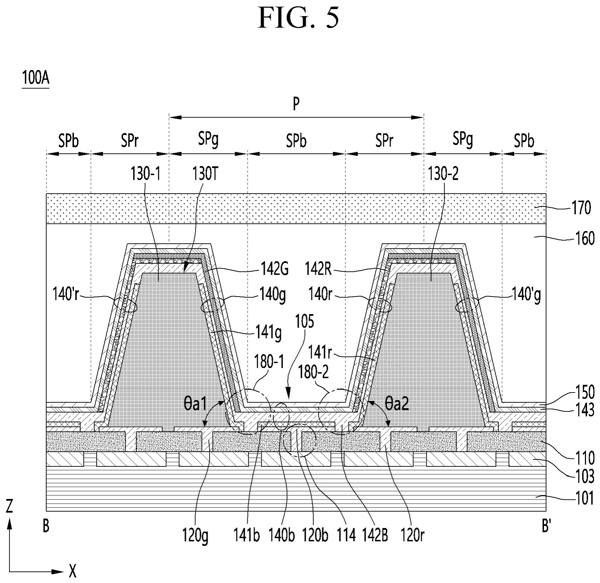

Hereinafter, various organic light-emitting display devices will be described with reference to FIGS. 5 to 8. FIGS. 5 to 8 are cross-sectional views taken along line B-B' in FIG. 1, respectively.

FIG. 5 is a cross-sectional view showing an organic light-emitting display device according to a first embodiment.

The organic light-emitting display device 100A shown in FIG. 5 can be the organic light-emitting display device shown in FIG. 2 or 3, and the side surfaces 130-1a and 130-1b of the first three-dimensional structure 130-1 and the side surfaces 130-2a and 130-2b of the second three-dimensional structure 130-2 can be inclined with respect to the substrate 101.

Referring to FIG. 5, the organic light-emitting display device 100A according to the first embodiment can comprise a first three-dimensional structure 130-1, a second three-dimensional structure 130-2, a green organic light-emitting element 140g, a red organic light-emitting element 140r, a blue organic light-emitting element 140b, etc.

The first three-dimensional structure 130-1 and the second three-dimensional structure 130-2 can be disposed on the substrate 101. The first three-dimensional structure 130-1 and the second three-dimensional structure 130-2 can have square pillars or rhombus pillars (FIGS. 2 to 4). The side surfaces 130-1a and 130-1b of the first three-dimensional structure 130-1 and the side surfaces 130-2a and 130-2b of the second three-dimensional structure 130-2 can be inclined with respect to the substrate 101. In this case, the average wall angle θa can be greater than 60 degrees and less than 90 degrees.

Meanwhile, the three-dimensional structures 130-1 and 130-2 can have a flat or rounded upper surface 130T. For example, in the case of a photo process, it is advantageous for thickness management to be flat, and in the case of a printing process, it does not necessarily need to be flat. Although not shown, the three-dimensional structures 130-1 and 130-2 can have vertices instead of the upper surface 130T.

Meanwhile, the first three-dimensional structure 130-1 and the second three-dimensional structure 130-2 can be separated into unit of one pixel P or units of two or more pixels P along the second direction Y, respectively, or can have a stripe shape.

The green subpixel SPg can be disposed on the first side surface 130-1a of the first three-dimensional structure 130-1, the red subpixel SPr can be disposed on the first side surface 130-2a of the second three-dimensional structure 130-2, and the blue subpixel SPb can be disposed on the separation region 105. The separation region 105 can be an area on the substrate 101 between the first three-dimensional structure 130-1 and the second three-dimensional structure 130-2.

The first side surface 130-1a of the first three-dimensional structure 130-1 and the first side surface 130-2a of the second three-dimensional structure 130-2 can contact both sides of the separation region 105.

The area of the separation region 105 can vary depending on the separation distance between the first three-dimensional structure 130-1 and the second three-dimensional structure 130-2. Accordingly, the area of the blue subpixel SPb disposed on the separation region 105 can be determined by the area of the separation region 105. As the separation distance increases, the area of the separation region 105 increases, and the area of the blue subpixel SPb can increase. If the area of the blue subpixel SPb increases, luminance increases, but this can work against the increase in resolution. Accordingly, the separation distance between the first three-dimensional structure 130-1 and the second three-dimensional structure 130-2 can be determined considering the resolution.

The green organic light-emitting element 140g can be disposed in the green subpixel SPg, the red organic light-emitting element 140r can be disposed in the red subpixel SPr, and the blue organic light-emitting element 140b can be disposed in the blue subpixel SPb.

The green organic light-emitting element 140g can comprise a first anode electrode 141g, a green organic light-emitting layer 142G, and a cathode electrode 143. The red organic light-emitting element 140r can comprise a second anode electrode 141r, a red organic light-emitting layer 142R, and a cathode electrode 143. The blue organic light-emitting element 140b can comprise a third anode electrode 141b, a blue organic light-emitting layer 142B, and a cathode electrode 143. The green organic light-emitting element 140g, the red organic light-emitting element 140r, and the blue organic light-emitting element 140b can comprise more layers than these.

The green organic light-emitting layer 142G can be named the first organic light-emitting layer, the red organic light-emitting layer 142R can be named the second organic light-emitting layer, and the blue organic light-emitting layer 142B can be named the third organic light-emitting layer.

The first anode electrode 141g and the green organic light-emitting layer 142G of the green organic light-emitting element 140g can be disposed in the green subpixel SPg on the first side surface 130-1a of the first three-dimensional structure 130-1. The second anode electrode 141r and the red organic light-emitting layer 142R of the red organic light-emitting element 140r can be disposed in the red subpixel SPr on the first side surface 130-2a of the second three-dimensional structure 130-2. The third anode electrode 141b and the blue organic light-emitting layer 142B of the blue organic light-emitting element 140b can be disposed in the blue subpixel SPb on the separation region 105.

The cathode electrode 143 can be commonly disposed in the green subpixel SPg, the red subpixel SPr, and the blue subpixel SPb. The cathode electrode 143 can be commonly disposed in the entire area of the substrate 101, for example, all pixels P or all subpixels SPg, SPr, and SPb.

In an embodiment, the blue organic light-emitting layer 142B can be disposed not only in the blue subpixel SPb but also in the green subpixel SPg and the red subpixel SPr. That is, the blue organic light-emitting layer 142B can be commonly disposed in the entire area of the substrate 101, for example, all pixels P or all subpixels SPg, SPr, and SPb. This structure can be referred to as a blue common structure. In this blue common structure, the blue organic light-emitting layer 142B can be disposed on the side surfaces 130-1a and 130-1b of the first three-dimensional structure 130-1, the side surfaces 130-2a and 130-2b of the second three-dimensional structure 130-2, and the separation region 105. The blue organic light-emitting layer 142B can be disposed between the first anode electrode 141g and the green organic light-emitting layer 142G in the green subpixel SPg. The blue organic light-emitting layer 142B can be disposed between the second anode electrode 141r and the red organic light-emitting layer 142R in the red subpixel SPr.

According to an embodiment, the green organic light-emitting layer 142G, the red organic light-emitting layer 142R, and the blue organic light-emitting layer 142B can be formed in the green subpixel SPg, the red subpixel SPr, and the blue subpixel SPb, respectively, without using FMM. That is, the green organic light-emitting layer 142G, the red organic light-emitting layer 142R, and the blue organic light-emitting layer 142B can be formed using a self-aligned deposition (SAD) method and the first three-dimensional structure 130-1 and the second three-dimensional structure 130-2. The SAD method will be described later.

Meanwhile, the organic light-emitting display device 100A according to the first embodiment can comprise a substrate 101, a plurality of driving circuits 103, a protective layer 110, and a plurality of auxiliary electrodes 120g, 120r, and 120b.

The plurality of driving circuits 103 can be disposed on the substrate 101, the protective layer 110 can be disposed on the plurality of driving circuits 103, and the plurality of auxiliary electrodes 120g, 120r, and 120b can be disposed on the protective layer 110. The auxiliary electrode can be called a pixel electrode.

The substrate 101 can be made of a silicon wafer, glass, plastic, ceramic, etc. The substrate 101 can be made of a transparent or opaque material. The driving circuit 103 can comprise a plurality of transistors and at least one or more capacitor. One transistor among the plurality of transistors can be a driving transistor.

The protective layer 110 can be a single layer made of an inorganic film or an organic film. The protective layer 110 can be a multi-layer of an inorganic film or a combination of a multi-layer of an inorganic film and an organic film. The protective layer 110 can be formed of a silicon oxide film (SiOx), a silicon nitride film (SiNx), or a multilayer thereof.

For example, the protective layer 110 can be composed of a multiple structure of an organic layer and an inorganic layer. In this case, the organic layer can comprise acryl resin, epoxy resin, phenolic resin, polyamide resin, polyimide resin, etc. The inorganic layer can comprise a silicon oxide layer (SiOx), a silicon nitride layer (SiNx), etc.

The plurality of auxiliary electrodes 120g, 120r, and 120b can be provided to correspond to the plurality of subpixels SPg, SPr, and SPb. For example, the first auxiliary electrode 120g can be connected to the green subpixel SPg, the second auxiliary electrode 120r can be connected to the red subpixel SPr, and the third auxiliary electrode 120b can be connected to the blue subpixel SPb. For example, the first auxiliary electrode 120g can be connected to the green organic light-emitting element 140g, the second auxiliary electrode 120r can be connected to the red organic light-emitting element 140r, and the third auxiliary electrode 120b can be connected to the blue organic light-emitting element 140b.

Meanwhile, the first auxiliary electrode 120g, the second auxiliary electrode 120r, and the third auxiliary electrode 120b can each connect the green organic light-emitting element 140g, the red organic light-emitting element 140r, and the blue organic light-emitting element 140b to the corresponding driving circuits 103 through the through hole 114 of the protective layer 110. The plurality of auxiliary electrodes 120g, 120r, and 120b can apply power or signals to the plurality of subpixels SPg, SPr, and SPb, or can be used as pads or terminals for inspection.

As described above, the auxiliary electrodes 120g, 120b, and 120r can electrically connect the driving circuits 103 and the anode electrodes 141g, 141r, and 141b of the organic light-emitting elements 140g, 140r, and 140b. For example, the auxiliary electrodes 120g, 120b, and 120r can be formed of a single layer such as Ti or Mo to improve contact resistance characteristics. For example, the auxiliary electrodes 120g, 120b, and 120r can have an oxide film such as ITO or IZO formed on a single layer such as Ti or Mo for fairness and reliability. For example, the auxiliary electrodes 120g, 120b, and 120r can have a double structure of ITO/(Ti or Mo). For example, the auxiliary electrodes 120g, 120b, and 120r can have a triple structure of (Ti or Mo)/ITO/(Ti or Mo).

Meanwhile, in the blue subpixel SPb, the third auxiliary electrode 120b can replace the third anode electrode 141b. In this case, the third anode electrode 141b can be omitted from the blue subpixel SPb. In other words, the third auxiliary electrode 120b is required to have low connection resistance with the drain electrode of the driving transistor of the driving circuit 103, have excellent reflection performance, or be suitable for the Work Function value (>4.8 eV) of the third anode electrode 141b. In this case, only the first anode electrode 141g of the green organic light-emitting element 140g and the second anode electrode 141r of the red organic light-emitting element 140r can be formed. For example, after the first anode electrode 141g of the green organic light-emitting element 140g, the second anode electrode 141r of the red organic light-emitting element 140r, and the third anode electrode 141b of the blue organic light-emitting element 140b are formed, the third anode electrode 141b can be removed.

The first three-dimensional structure 130-1 can be disposed on the first auxiliary electrode 120g, and the second three-dimensional structure 130-2 can be disposed on the second auxiliary electrode 120r. A partial end of the first auxiliary electrode 120g can be electrically connected to the first anode electrode 141g disposed in the green subpixel SPg on the first side surface 130-1a of the first three-dimensional structure 130-1. A partial end of the second auxiliary electrode 120r can be electrically connected to the second anode electrode 141r disposed in the red subpixel SPr on the first side surface 130-2a of the second three-dimensional structure 130-2.

The first three-dimensional structure 130-1 and the second three-dimensional structure 130-2 can be made of an inorganic film or an organic resin. The first three-dimensional structure 130-1 and the second three-dimensional structure 130-2 can have a dual structure of an organic resin on an inorganic film. The organic resin can be black resin, but is not limited thereto. When the black resin is used as the organic resin, external or internal light can be absorbed by the black resin, so that image quality, such as contrast characteristics and color unevenness due to light leakage, can be improved.

In selecting this material, a material that is easy to process can be selected depending on the height of the first three-dimensional structure 130-1 and/or the second three-dimensional structure 130-2 and the size of the width of the lower surface of the first three-dimensional structure 130-1 and/or the second three-dimensional structure 130-2 according to the resolution.

Meanwhile, the organic light-emitting display device 100A according to the first embodiment can comprise a first insulating layer 150, a second insulating layer 160, a third insulating layer 170, etc. The first insulating layer 150 can be made of an inorganic material, the second insulating layer 160 can be made of an organic material, and the third insulating layer 170 can be made of an inorganic material, but is not limited thereto.

The first insulating layer 150 can be disposed on the green organic light-emitting element 140g, the red organic light-emitting element 140r, and the blue organic light-emitting element 140b. That is, the first insulating layer 150 can be disposed on the side surfaces 130-1a and 130-1b and the upper surface 130T of the first three-dimensional structure 130-1, the side surfaces 130-2a and 130-2b and the upper surface 130T of the second three-dimensional structure 130-2,

and the separation region 105. Since the first insulating layer 150 has a relatively thin thickness, it can be formed to be curved according to the shape of each of the first three-dimensional structure 130-1 and the second three-dimensional structure 130-2.

The second insulating layer 160 can be disposed on the first insulating layer 150 between the first three-dimensional structure 130-1 and the second three-dimensional structure 130-2. The second insulating layer 160 can be disposed on the upper surface 130T of each of the first three-dimensional structure 130-1 and the second three-dimensional structure 130-2. That is, the second insulating layer 160 can cover the first insulating layer 150 disposed on the upper surface 130T of each of the first three-dimensional structure 130-1 and the second three-dimensional structure 130-2. Since the second insulating layer 160 requires a large thickness, it can be formed of an organic material that is easy to form a large thickness during the process. The second insulating layer 160 can be a planarization layer that flattens the upper surface 130T to facilitate formation of the third insulating layer 170.

The third insulating layer 170 can be disposed on the second insulating layer 160.

The first insulating layer 150, the second insulating layer 160, and the third insulating layer 170 can serve to prevent penetration of oxygen, moisture, etc. and relieve impact. Since the first insulating layer 150 and the third insulating layer 170 are made of an inorganic material, the penetration of oxygen or moisture can be completely blocked.

At least one or more layer can be added on the third insulating layer 170. For example, a planarization layer, an anti-reflection layer, a PSA layer, a cover film, etc. can be disposed on the third insulating layer 170.

The substrate 101 described above can be a silicon substrate on which a plurality of driving circuits 103 are formed using a semiconductor process. Alternatively, a glass substrate or a plastic substrate can be used. In addition to this, organic light-emitting display devices manufactured using various materials, structures, methods, processes, etc. can be obtained.

According to the embodiment, each of the green subpixel SPg, the red subpixel SPr, and the blue subpixel SPb can be disposed on the side surfaces 130-1a and 130-1b of the first three-dimensional structure 130-1, the side surfaces 130-2a and 130-2b of the second three-dimensional structure 130-2, and the separation region 105 between the first three-dimensional structure 130-1 and the second three-dimensional structure 130-2. Accordingly, the light-emitting area of each of the green subpixel SPg and the red subpixel SPr can be maintained or expanded, but the occupied area is reduced, so that a high-precision and high-resolution display can be implemented.

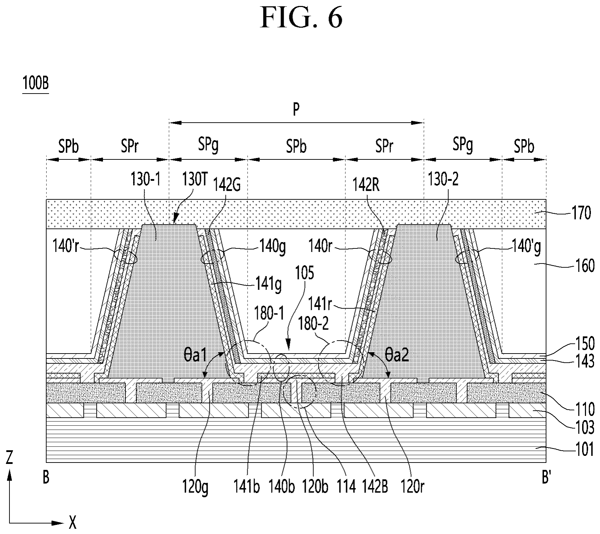

FIG. 6 is a cross-sectional view showing an organic light-emitting display device according to a second embodiment.

The second embodiment is the same as the first embodiment (FIG. 5) except that the third insulating layer 170 can contact the upper surface 130T of each of the first three-dimensional structure 130-1 and the second three-dimensional structure 130-2. In the second embodiment, components having the same structure, shape, and/or function as those of the first embodiment are given the same reference numerals and detailed descriptions are omitted.

The organic light-emitting display device shown in FIG. 6 can be the organic light-emitting display device shown in FIGS. 2 and 3, and the side surfaces 130-1a and 130-1b of the first three-dimensional structure 130-1 and the side surfaces 130-2a and 130-2b of the second three-dimensional structure 130-2 can be inclined with respect to the substrate 101.

Referring to FIG. 6, the organic light-emitting display device 100B according to the second embodiment can comprise a substrate 101, a plurality of driving circuits 103, a protective layer 110, a plurality of auxiliary electrodes 120g, 120r, and 120b, etc. The organic light-emitting display device 100B according to the second embodiment can comprise a first three-dimensional structure 130-1, a second three-dimensional structure 130-2, a green organic light-emitting element 140g, a red organic light-emitting element 140r, a blue organic light-emitting element 140b, etc. The organic light-emitting display device 100B according to the second embodiment can comprise a first insulating layer 150, a second insulating layer 160, a third insulating layer 170, etc.

The green organic light-emitting element 140g can be disposed on the first side surface 130-1a of the first three-dimensional structure 130-1, and the red organic light-emitting element 140r can be disposed on the first side surface 130-2a of the second three-dimensional structure 130-2. The blue organic light-emitting element 140b can be disposed on the separation region 105 between the first three-dimensional structure 130-1 and the second three-dimensional structure 130-2. The green organic light-emitting element 140g can be disposed in the green subpixel SPg, the red organic light-emitting element 140r can be disposed in the red subpixel SPr, and the blue organic light-emitting element 140b can be disposed in the blue subpixel SPb. One pixel P can be composed of green subpixel SPg, the red subpixel SPr, and the blue subpixel SPb.

The side surfaces 130-1a and 130-1b of the first three-dimensional structure 130-1 and the side surfaces 130-2a and 130-2b of the second three-dimensional structure 130-2 can be inclined with respect to the substrate 101. For example, the average wall angle $\theta a$ can be greater than 60 degrees and less than 90 degrees.

The third insulating layer 170 can be in contact with the upper surface 130T of the first three-dimensional structure 130-1. The third insulating layer 170 can be in contact with the upper surface 130T of the second three-dimensional structure 130-2.

The second embodiment can be a modified example of the first embodiment (FIG. 5). That is, according to the first embodiment (FIG. 5), a green organic light-emitting layer 142G, a red organic light-emitting layer 142R, a blue organic light-emitting layer 142B, a cathode electrode 143 a first insulating layer 150, and a second insulating layer 160 are formed on the upper surface 130T of each of the first three-dimensional structure 130-1 and the second three-dimensional structure 130-2. Thereafter, the second insulating layer 160, the first insulating layer 150, the cathode electrode 143, the green organic light-emitting layer 142G, the red organic light-emitting layer 142R, and the blue organic light-emitting layer 142B on the upper surface 130T of each of the first three-dimensional structure 130-1 and the second three-dimensional structure 130-2can be removed, so that the upper surface 130T of the first three-dimensional structure 130-1 and the upper surface 130T of of the second three-dimensional structure 130-2 can be exposed. Thereafter, the third insulating layer 170 can be formed on of the upper surface 130T of the first three-dimensional structure 130-1, the upper surface 130T of the first three-dimensional structure 130-1, and the second insulating layer 160 between the first three-dimensional structure 130-1 and the second three-dimensional structure 130-2. Accordingly, as in the second embodiment, the third insulating layer 170 can contact the upper surface 130T of the first three-dimensional structure 130-1 and the upper surface 130T of the second three-dimensional structure 130-2.

Although not shown, a charge generation layer CGL common to the green subpixel SPg, the red subpixel SPr, and the blue subpixel SPb can be formed on the upper surface 130T of each of the first three-dimensional structure 130-1 and the second three-dimensional structure 130-2. In this case, the charge generation layer CGL can be removed on the upper surface 130T of each of the first three-dimensional structure 130-1 and the second three-dimensional structure 130-2 and the charge generation layer CGL of the green subpixel SPg and the charge generation layer CGL of the red subpixel SPr can be disconnected, thereby preventing lateral current leakage between each subpixel.

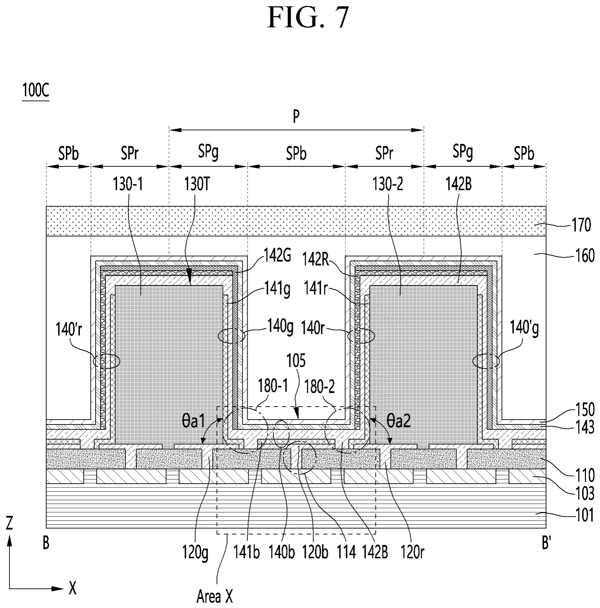

FIG. 7 is a cross-sectional view showing an organic light-emitting display device according to a third embodiment.

The third embodiment is the same as the first embodiment (FIG. 5) or the second embodiment (FIG. 6) except that the side surfaces 130-1a and 130-1b of the first three-dimensional structure 130-1 and the side surfaces 130-2a and 130-2b of the second three-dimensional structure 130-2 are perpendicular to the substrate 101. In the third embodiment, components having the same structure, shape, and/or function as those of the first embodiment (FIG. 5) or the second embodiment (FIG. 6) are given the same reference numerals and detailed descriptions are omitted.

The organic light-emitting display device shown in FIG. 7 can be the organic light-emitting display device shown in FIG. 4, and the side surfaces 130-1a and 130-1b of the first three-dimensional structure 130-1 and the side surfaces 130-2a and 130-2b of the second three-dimensional structure 130-2 can be perpendicular to the substrate 101.

Referring to FIG. 7, the organic light-emitting display device 100C according to the third embodiment can comprise a substrate 101, a plurality of driving circuits 103, a protective layer 110, a plurality of auxiliary electrodes 120g, 120r, and 120b, etc. The organic light-emitting display device 100C according to the third embodiment can comprise a first three-dimensional structure 130-1, a second three-dimensional structure 130-2, a green organic light-emitting element 140g, a red organic light-emitting element 140r, a blue organic light-emitting element 140b, etc. The organic light-emitting display device 100C according to the third embodiment can comprise a first insulating layer 150, a second insulating layer 160, a third insulating layer 170, etc.

The green organic light-emitting element 140g can be disposed on the first side surface 130-1a of the first three-dimensional structure 130-1, and the red organic light-emitting element 140r can be disposed on the first side surface 130-2a of the second three-dimensional structure 130-2. The blue organic light-emitting element 140b can be disposed on the separation region 105 between the first three-dimensional structure 130-1 and the second three-dimensional structure 130-2. The green organic light-emitting element 140g can be disposed in the green subpixel SPg, the red organic light-emitting element 140r can be disposed in the red subpixel SPr, and the blue organic light-emitting element 140b can be disposed in the blue subpixel SPb. One pixel P can be composed of green subpixel SPg, the red subpixel SPr, and the blue subpixel SPb.

The side surfaces 130-1a and 130-1b of the first three-dimensional structure 130-1 and the side surfaces 130-2a and 130-2b of the second three-dimensional structure 130-2 can be perpendicular to the substrate 101. For example, the average wall angle $\theta a$ can be 90 degrees. A green organic light-emitting element 140g can be disposed on the first side surface 130-1a of the first three-dimensional structure 130-1, and a red organic light-emitting element 140r can be disposed on the first side surface 130-2a of the second three-dimensional structure 130-2. Since the side surfaces 130-1a and 130-1b of the first three-dimensional structure 130-1 and the side surfaces 130-2a and 130-2b of the second three-dimensional structure 130-2 are perpendicular to the substrate 101, when viewed from the front, the occupied area of the green organic light-emitting element 140g and the occupied area of the red organic light-emitting element 140r can be minimized, so that a display with ultra-high resolution can be implemented.

Since the average wall angle $\theta a$ is 90 degrees, in the blue common structure, the blue organic light-emitting layer 142B may not be formed on the side surfaces 130-1a and 130-1b of the first three-dimensional structure 130-1 or the side surfaces 130-2a and 130-2b of the second three-dimensional structure 130-2, or can be formed with a very thin thickness. Accordingly, the blue organic light-emitting layer 142B, which should not affect the light emission of each of the green subpixel SPg and the red subpixel SPr, is not formed or is formed with a minimum thickness, thereby preventing color purity deterioration or defects due to color unevenness.

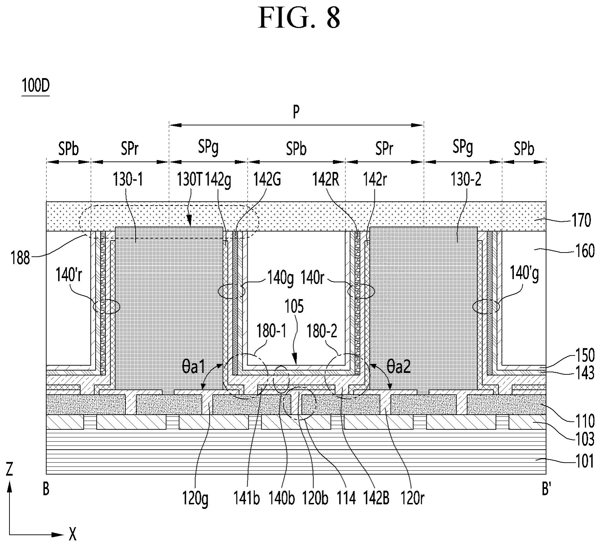

FIG. 8 is a cross-sectional view showing an organic light-emitting display device according to a fourth embodiment.

The fourth embodiment is the same as the first embodiment (FIG. 5) or the second embodiment (FIG. 6) except that the side surfaces 130-1a and 130-1b of the first three-dimensional structure 130-1 and the side surfaces 130-2a and 130-2b of the second three-dimensional structure 130-2 are perpendicular to the substrate 101. In addition, the fourth embodiment is the same as the third embodiment (FIG. 7) except that the third insulating layer 170 is in contact with the upper surface 130T of each of the first three-dimensional structure 130-1 and the second three-dimensional structure 130-2. In the fourth embodiment, components having the same structure, shape and/or function as those of the first to third embodiments (FIGS. 5 to 7) are given the same reference numerals and detailed descriptions are omitted.

The organic light-emitting display device shown in FIG. 8 can be the organic light-emitting display device shown in FIG. 4, and the side surfaces 130-1a and 130-1b of the first three-dimensional structure 130-1 and the side surfaces 130-2a and 130-2b of the second three-dimensional structure 130-2 can be perpendicular to the substrate 101.

Referring to FIG. 8, the organic light-emitting display device 100D according to the fourth embodiment can comprise a substrate 101, a plurality of driving circuits 103, a protective layer 110, a plurality of auxiliary electrodes 120g, 120r, and 120b, etc. The organic light-emitting display device 100D according to the fourth embodiment can comprise a first three-dimensional structure 130-1, a second three-dimensional structure 130-2, a green organic light-emitting element 140g, a red organic light-emitting element 140r, a blue organic light-emitting element 140b, etc. The organic light-emitting display device 100D according to the fourth embodiment can comprise a first insulating layer 150, a second insulating layer 160, a third insulating layer 170, etc.

The green organic light-emitting element 140g can be disposed on the first side surface 130-1a of the first three-dimensional structure 130-1, and the red organic light-emitting element 140r can be disposed on the first side surface 130-2a of the second three-dimensional structure 130-2. The blue organic light-emitting element 140b can be disposed on the separation region 105 between the first three-dimensional structure 130-1 and the second three-dimensional structure 130-2. The green organic light-emitting element 140g can be disposed in the green subpixel SPg, the red organic light-emitting element 140r can be disposed in the red subpixel SPr, and the blue organic light-emitting element 140b can be disposed in the blue subpixel SPb. One pixel P can be composed of the green subpixel SPg, the red subpixel SPr, and the blue subpixel SPb.

The third insulating layer 170 can be in contact with the upper surface 130T of the first three-dimensional structure 130-1. The third insulating layer 170 can be in contact with the upper surface 130T of the second three-dimensional structure 130-2.

The fourth embodiment can be a modified example of the third embodiment (FIG. 7). According to the third embodiment (FIG. 7), a green organic light-emitting layer 142G, a red organic light-emitting layer 142R, a blue organic light-emitting layer 142B, a cathode electrode 143, a first insulating layer 150 and a second insulating layer 160 can be formed on the upper surface 130T of each of the first three-dimensional structure 130-1 and the second three-dimensional structure 130-2. Thereafter, the second insulating layer 160, the first insulating layer 150, the cathode electrode 143, the green organic light-emitting layer 142G, the red organic light-emitting layer 142R, and the blue organic light-emitting layer 142B can be removed, so that the upper surface 130T of the first three-dimensional structure 130-1 and the upper surface 130T of the second three-dimensional structure 130-2 can be exposed. Thereafter, the third insulating layer 170 can be formed on the upper surface 130T of the first three-dimensional structure 130-1, the upper surface 130T of the first three-dimensional structure 130-1, and the second insulating layer 160 between the first three-dimensional structure 130-1 and the second three-dimensional structure 130-2. Accordingly, as in the second embodiment, the third insulating layer 170 can contact the upper surface 130T of the first three-dimensional structure 130-1 and the upper surface 130T of the second three-dimensional structure 130-2.

Although not shown, a charge generation layer CGL common to the green subpixel SPg, the red subpixel SPr, and the blue subpixel SPb can be formed on the upper surface 130T of each of the first three-dimensional structure 130-1 and the second three-dimensional structure 130-2. In this case, the charge generation layer CGL can be removed on the upper surface 130T of each of the first three-dimensional structure 130-1 and the second three-dimensional structure 130-2 and the charge generation layer CGL of the green subpixel SPg and the charge generation layer CGL of the red subpixel SPr can be disconnected, thereby preventing lateral current leakage between each subpixel.

Meanwhile, the organic light-emitting display device according to the first to fourth embodiments (FIGS. 5 to 8) can comprise a first anode separation structure 180-1 and a second anode separation structure 180-2. That is, one pixel P can be provided with two anode separation structures 180-1 and 18-2.

The first anode separation structure 180-1 can be provided along the perimeter of the first three-dimensional structure 130-1. The first anode separation structure 180-1 can be located between the green subpixel SPg and the blue subpixel SPb. The first anode separation structure 180-1 can be located in the lower side of the first three-dimensional structure 130-1 between the green subpixel SPg and the red subpixel SPr. The second anode separation structure 180-2 can be provided along the perimeter of the second three-dimensional structure 130-2. The second anode separation structure 180-2 can be located between the red subpixel SPr and the blue subpixel SPb. The second anode separation structure 180-2 can be located in the lower side of the second three-dimensional structure 130-2 between the red subpixel SPr and the blue subpixel SPb.

For example, during the deposition process to form an anode electrode, the first anode electrode 141g of the green organic light-emitting element 140g and the third anode electrode 141b of the blue organic light-emitting element 140b can be disconnected by the first anode separation structure 180-1. For example, during the deposition process, the second anode electrode 141r of the red organic light-emitting element 140r and the third anode electrode 141b of the blue organic light-emitting element 140b can be disconnected by the second anode separation structure 180-2. Therefore, a separate patterning process is not required to separate the first anode electrode 141g and the third anode electrode 141b or the second anode electrode 141r and the third anode electrode 141b, so that defects caused by the pattern process can be prevented, the process can be simplified, and costs can be reduced.

For example, the green subpixel SPg, the blue subpixel SPb, and the red subpixel SPr can be disposed in the order along the first direction X, and a charge generation layer CGL can be commonly formed in the green subpixel SPg, the blue subpixel SPb, and the red subpixel SPr. In this case, lateral current leakage LCL can occur between the green organic light-emitting element 140g on the green subpixel SPg, the red organic light-emitting element 140r on the red subpixel SPr, and the blue organic light-emitting element 140b on the blue subpixel SPb through the charge generation layer CGL. However, according to the embodiment, the charge generation layer CGL commonly formed in the green subpixel SPg, the red subpixel SPr, and the blue subpixel SPb can be disconnected by the first anode separation structure 180-1 and the second anode separation structure 180-2, respectively. That is, the charge generation layer CGL located between the green subpixel SPg and the blue subpixel SPb can be disconnected by the first anode separation structure 180-1. The charge generation layer CGL located between the red subpixel SPr and the blue subpixel SPb can be disconnected by the second anode separation structure 180-2. Therefore, lateral current leakage flowing between the green organic light-emitting element 140g, the red organic light-emitting element 140r, and the blue organic light-emitting element 140b can be prevented by the charge generation layer CGL commonly formed in the green organic light-emitting element 140g, the red organic light-emitting element 140r, and the blue organic light-emitting element 140b.

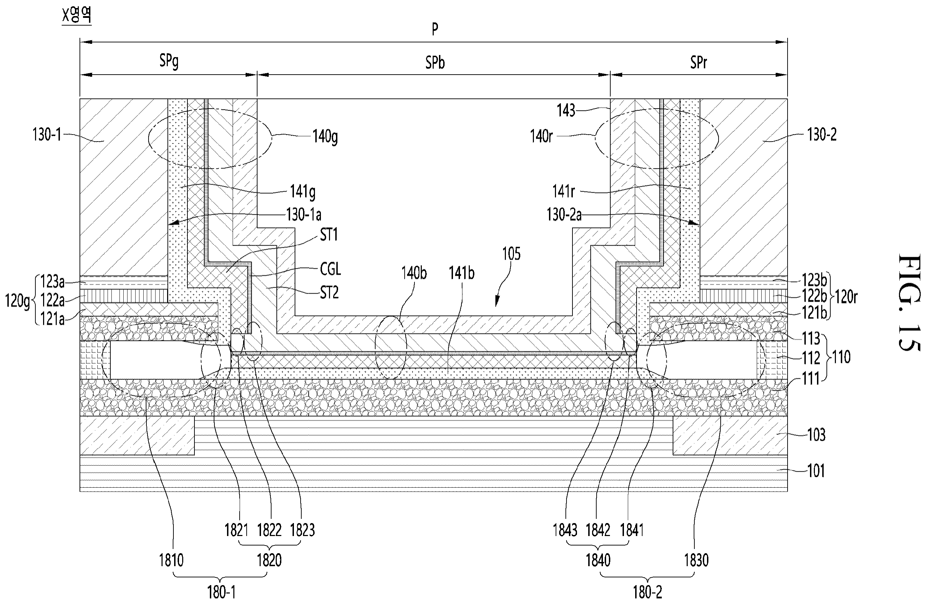

The first anode separation structure 180-1 and the second anode separation structure 180-2 will be described in detail later with reference to FIGS. 15 to 18.

Meanwhile, in the embodiment, the anode electrodes 141g, 141r, and 141b can be formed of a transparent conductive film or a reflective film. The transparent conductive film can be formed to a thickness of less than 50 nanometers using a sputtering method with a transparent conductive material (TCO) such as ITO or IZO that can transmit light. A metal film can be formed on the transparent conductive film using electroplating.

According to an embodiment, the transparent conductive film of the anode electrodes 141g, 141r, and 141b can be formed to a thickness of less than 50 nanometers, or the anode electrodes 141g, 141r, and 141b can be connected to the auxiliary electrodes 120g, 120b, and 120r and the side surfaces 130-1a, 130-1b, 130-2a and 130-2b of the three-dimensional structures 130-1 and 130-2, so that it can be fundamentally formed into a structure without steps. Alternatively, anode separation structures 180-1 and 180-2 can be provided. Accordingly, point defects caused by short circuits between the anode electrodes 141g, 141r, and 141b and the cathode electrode 143 or leakage current between pixels P (or subpixels) can be prevented without forming banks such as PDL (Pixel define layer).

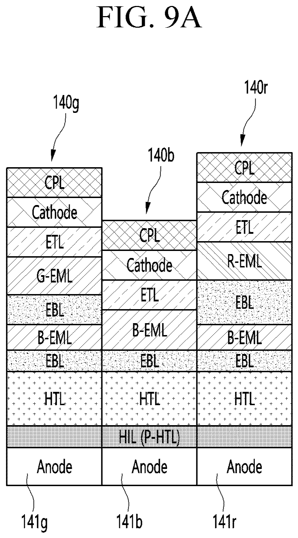

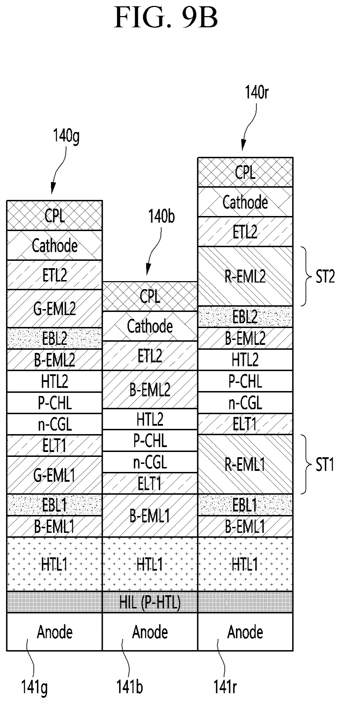

FIG. 9A is a cross-sectional view showing a stacked structure for each organic light-emitting element according to the first embodiment. FIG. 9B is a cross-sectional view showing a stacked structure for each organic light-emitting element according to the second embodiment.

The green organic light-emitting element 140g, the red organic light-emitting element 140r, and the blue organic light-emitting element 140b can be composed of one stack (FIG. 9A) or a tandem structure comprising two stacks ST1 and ST2 (FIG. 9B). Although not shown, it can consist of three or more stacks.

As shown in FIG. 9A, the green organic light-emitting element 140g, the red organic light-emitting element 140r, and the blue organic light-emitting element 140b can be composed of one stack comprising one green organic light-emitting layer G-EML, one red organic light-emitting layer R-EML, and one blue organic light-emitting layer B-EML.

The green organic light-emitting element 140g can comprise a green organic light-emitting layer G-EML between the first anode electrode 141g and the cathode electrode. The red organic light-emitting element 140r can comprise a red organic light-emitting layer R-EML between the second anode electrode 141r and the cathode electrode. The blue organic light-emitting element 140b can comprise a blue organic light-emitting layer B-EML between the third anode electrode 141b and the cathode electrode.

The green organic light-emitting element 140g, the red organic light-emitting element 140r, and the blue organic light-emitting element 140b can each comprise a hole injection layer HIL, a hole transport layer HTL, an organic light-emitting layer EML, an electron transport layer ETL, and an electron injection layer. Additionally, the green organic light-emitting element 140g, the red organic light-emitting element 140r, and the blue organic light-emitting element 140b can each comprise at least one or more electron blocking layer EBL. A capping layer CPL can be formed on the cathode electrode in each of the green organic light-emitting element 140g, the red organic light-emitting element 140r, and the blue organic light-emitting element 140b. The hole injection layer HIL, the hole transport layer HTL, the electron transport layer ETL, the electron injection layer, the cathode electrode, and the capping layer CPL can also be commonly included in the green organic light-emitting element 140g, the red organic light-emitting element 140r, and the blue organic light-emitting element 140b.

The cathode electrode can be formed of a transparent conductive film, a semi-transmissive film, a reflective film, etc. The semi-permeable film can be formed using an alloy (Mg:Ag) of magnesium Mg and silver Ag with a thickness of 20 nanometers or less. The semi-transmissive film can be composed of a double layer. That is, the semi-transmissive film can comprise a first layer containing an Mg:Ag alloy and a second layer containing a transparent conductive material (TCO) such as ITO or IZO on top of the first layer. When the cathode electrode is made of only a transparent film, the transparent film can be formed only of a transparent conductive film containing a transparent conductive material (TCO).

When voltage is applied to the first anode electrode 141g and the cathode electrode of 140g of the green organic light-emitting element, holes and electrons move to the green organic light-emitting layer G-EML through the hole transport layer HTL and in the green organic light-emitting layer G-EML, holes and electrons can combine with each other to emit light. Likewise, the red organic light-emitting element 140r and the blue organic light-emitting element 140b can also emit light by combining holes and electrons.

In the blue common structure, the blue organic light-emitting layer B-EML can be commonly included in not only the blue organic light-emitting element 140b, but also the green organic light-emitting element 140g and the red organic light-emitting element 140r.

As shown in FIG. 9B, the green organic light-emitting element 140g, the red organic light-emitting element 140r, and the blue organic light-emitting element 140b can be composed of two stacks ST1 and ST2 comprising two organic light-emitting layers. The green organic light-emitting element 140g can be composed of two stacks ST1 and ST2 comprising two green organic light-emitting layers G-EML1 and G-EML2 between the first anode electrode 141g and the cathode electrode. The red organic light-emitting element 140r can be composed of two stacks ST1 and ST2 comprising two red organic light-emitting layers R-EML1 and R-EML2 between the second anode electrode 141r and the cathode electrode. The blue organic light-emitting element 140b can be composed of two stacks ST1 and ST2 comprising two blue organic light-emitting layers B-EML1 and B-EML2 between the third anode electrode 141b and the cathode electrode.

The green organic light-emitting element 140g, the red organic light-emitting element 140r, and the blue organic light-emitting element 140b can each comprise a hole injection layer HIL, two hole transport layers HTL1 and HTL2, two electron transport layers ETL1 and ETL2, two electron blocking layers EBL1 EBL2, etc. A capping layer CPL can be formed on the cathode electrode in each of the green organic light-emitting element 140g, the red organic light-emitting element 140r, and the blue organic light-emitting element 140b. The hole injection layer HIL, the hole transport layers HTL1 and HTL2, the electron transport layesr ETL1 and ETL2, the electron blocking layers EBL1 and EBL2, and the capping layer CPL can also be commonly included in the green organic light-emitting element 140g and the red organic light-emitting element 140r.

In particular, a charge generation layer can be formed between the first stack ST1 and the second stack ST2 in the green organic light-emitting element 140g, the red organic light-emitting element 140r, and the blue organic light-emitting element 140b. For example, the charge generation layer can comprise a first charge generation layer formed adjacent to the first stack ST1, that is, an n-type charge generation layer n-CGL, and a second charge generation layer formed between the first charge generation layer and the second stack ST2, that is, a p-type charge generation layer p-CGL. The n-type charge generation layer n-CGL can inject electrons into the first stack ST1, and the p-type charge generation layer p-CGL can inject holes into the second stack ST2. The n-type charge generation layer n-CGL can be made of an organic layer doped with an alkali metal such as Li, Yb, Na, K, or Cs, or an alkaline earth metal such as Mg, Sr, Ba, or Ra. The p-type charge generation layer p-CGL can be formed by doping the hole transport layer HTL2 with a dopant.

As described above, as the charge generation layer is made of a low-resistance material and is commonly formed in the green organic light-emitting element 140g, the red organic light-emitting element 140r, and the blue organic light-emitting element 140b, lateral current leakage can occur between the green subpixel SPg, the red subpixel SPr and the blue subpixel SPb. As will be explained later, by disconnecting the charge generation layer located between the green subpixel SPg, the red subpixel SPr, and the blue subpixel SPb, lateral current leakage between each subpixel can be prevented.

Meanwhile, in the blue common structure, the two blue organic light-emitting layers B-EML1 and B-EML2 can be commonly included in the green organic light-emitting element 140g and the red organic light-emitting element 140r. The first blue organic light-emitting layer B-EML1 can be located below the first stack ST1, and the second blue organic light-emitting layer B-EML2 can be located between the first stack ST1 and the second stack ST2.

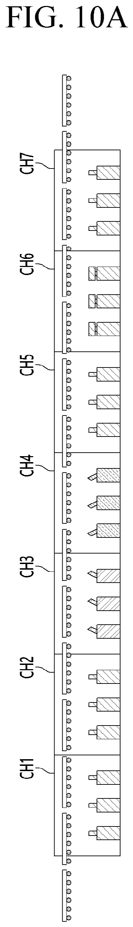

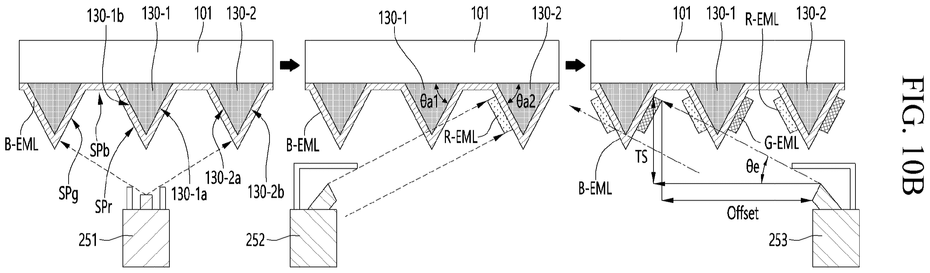

FIG. 10A shows a deposition system according to an embodiment. FIG. 10B shows the deposition of a blue organic light-emitting layer, a red organic light-emitting layer, and a green organic light-emitting layer on a substrate.

Although the top of the three-dimensional structure is shown as a vertex in FIG. 10B, it can also have an upper surface as shown in FIGS. 5 to 8. In the drawing, seven chambers CH1 to CH7 are provided, but more chambers can be provided.

As shown in FIGS. 5 to 8, 9A, 10A, and 10B, the deposition system according to the embodiment can operate in an in-line manner. That is, as the substrate 101 passes through the first to seventh chambers CH1 to CH7 along one direction, the green organic light-emitting element 140g, the red organic light-emitting element 140r, and the blue organic light-emitting element 140b can be formed on the substrate 101. That is, as the substrate 101 is transferred, the green organic light-emitting element 140g, the red organic light-emitting element 140r, and the blue organic light-emitting element 140b can be deposited on the green subpixel SPg, the red subpixel SPr, and the blue subpixel SPb on the substrate 101.

A hole injection layer HIL and/or a hole transport layer HTL can be deposited on the substrate 101 in the first chamber CH1. The hole injection layer HIL and the hole transport layer HTL can each be deposited in separate chambers. A blue organic light-emitting layer B-EML can be deposited on the substrate 101 in the second chamber CH2. A red organic light-emitting layer R-EML can be deposited on the substrate 101 in the third chamber CH3. A green organic light-emitting layer G-EML can be deposited on the substrate 101 in the fourth chamber CH4. An electron transport layer ETL can be deposited on the substrate 101 in the fifth chamber CH5. An electron injection layer EIL and/or a cathode electrode can be deposited on the substrate 101 in the sixth chamber CH6. The electron injection layer EIL and the cathode electrode can each be deposited in separate chambers. A capping layer CPL can be deposited on the substrate 101 in the seventh chamber CH7.

As shown in FIG. 9B, when the green organic light-emitting element 140g, the red organic light-emitting element 140r, and the blue organic light-emitting element 140b are each composed of two stacks ST1 and ST2, separate chambers, that is. The second chamber CH2 to the fourth chamber CH4, can be additionally disposed between the fourth chamber CH4 and the fifth chamber CH5. In this case, the substrate 101 passes through the second chamber CH2 to the fourth chamber CH4, so that the first stack ST1 comprising the first blue organic light-emitting layer B-EML1, the first red organic light-emitting layer R-RML1, and the first green organic light-emitting layer G-EML1 can be formed on the substrate 101. Thereafter, when the substrate 101 passes through the separate chambers, that is, the second chamber CH2 to the fourth chamber CH4, which are additionally disposed, the charge generation layer CGL and the second stack ST2 can be formed on the first stack ST1. The second stack ST2 can comprise a second blue organic light-emitting layer B-EML1, a second red organic light-emitting layer R-RML2, and a second green organic light-emitting layer G-EML2. Accordingly, each of the green organic light-emitting element 140g, the red organic light-emitting element 140r, and the blue organic light-emitting element 140b can have a tandem structure comprising a first stack ST1 and a second stack ST2. The first blue organic light-emitting layer B-EML1 and the second blue organic light-emitting layer B-EML1 can be commonly deposited on the green organic light-emitting element 140g, the red organic light-emitting element 140r, and the blue organic light-emitting element 140b, respectively.

As shown in FIGS. 10A and 10B, the substrate 101 can be transferred from left to right on a first evaporation source 251, a second evaporation source 252, and a third evaporation source 253. The first evaporation source 251 can be provided in the second chamber CH2, the second evaporation source 252 can be provided in the third chamber CH3, and the third evaporation source 253 can be provided in the fourth chamber CH4. The first evaporation source 251 can discharge a blue organic light-emitting material, the second evaporation source 252 can discharge a red organic light-emitting material, and the third evaporation source 253 can discharge a green organic light-emitting material. The first evaporation source 251 can discharge the blue organic light-emitting material in a vertical direction toward the substrate 101. The second evaporation source 252 can discharge the red organic light-emitting material in the first diagonal direction toward the substrate 101. The third evaporation source 253 can discharge the green organic light-emitting material in the second diagonal direction toward the substrate 101. The first diagonal direction and the second diagonal direction can be symmetrical to each other based on the normal direction.

Meanwhile, the first three-dimensional structure 130-1 and the second three-dimensional structure 130-2 can be provided on the substrate 101. As described above, a separation region 105 can be defined on the substrate 101 between the first three-dimensional structure 130-1 and the second three-dimensional structure 130-2.

After the substrate 101 is turned over so that the first three-dimensional structure 130-1 and the second three-dimensional structure 130-2 face the first evaporation source 251, the second evaporation source 252, and the third evaporation source 253, the substrate 101 can be transferred to each of the first chamber CH1, the second chamber CH2, and the third chamber CH3.

When the substrate 101 passes through the first chamber CH1, the blue organic light-emitting material vertically discharged from the first evaporation source 251 can be deposited on the entire area of the substrate 101. That is, it can be deposited on the side surfaces 130-1a and 130-1b of the first three-dimensional structure 130-1, the side surfaces 130-2a and 130-2b of the second three-dimensional structure 130-2, and the separation region 105. A blue organic light-emitting layer B-EML can be formed by the blue organic light-emitting material deposited on the separation region 105.

When the substrate 101 passes through the second chamber CH2, the red organic light-emitting material discharged from the second evaporation source 252 in the first diagonal direction can be deposited on the exposed area on the substrate 101. That is, the red organic light-emitting material can be deposited only on the second side surface 130-1b of the first three-dimensional structure 130-1 and the first side surface 130-2a of the second three-dimensional structure 130-2. A red organic light-emitting layer R-EML can be formed by the red organic light-emitting material deposited on each of the second side surface 130-1b of the first three-dimensional structure 130-1 and the first side surface 130-2a of the second three-dimensional structure 130-2. Since the red organic light-emitting material extending in the first diagonal direction is blocked by the first three-dimensional structure 130-1 and the second three-dimensional structure 130-2, the red organic light-emitting material may not be deposited on the first side surface 130-1a of the first three-dimensional structure 130-1and the separation region 105.

When the substrate 101 passes through the third chamber CH3, the green organic light-emitting material discharged from the third evaporation source 253 in the second diagonal direction can be deposited on the exposed area on the substrate 101. That is, the green organic light-emitting material can be deposited only on the first side surface 130-1a of the first three-dimensional structure 130-1 and the second side surface 130-2b of the second three-dimensional structure 130-2. A green organic light-emitting layer G-EML can be formed by the green organic light-emitting material deposited on each of the first side surface 130-1a of the first three-dimensional structure 130-1 and the second side surface 130-2b of the second three-dimensional structure 130-2. Since the green organic light-emitting material extending in the second diagonal direction is blocked by the first three-dimensional structure 130-1 and the second three-dimensional structure 130-2, the green organic light-emitting material may not be deposited on the first side surface 130-2a of the second three-dimensional structure 130-2 and the separation region 105.

Therefore, as the substrate 101 passes through the second chamber CH2 and the third chamber CH3, the blue organic light-emitting material can be deposited on the entire area of the substrate 101 comprising the separation region 105, the red organic light-emitting material can be deposited only on the first side surface 130-2a of the second three-dimensional structure 130-2, and the green organic light-emitting material can be deposited only on the first side surface 130-1a of the first three-dimensional structure 130-1.

According to an embodiment, a blue organic light-emitting layer EML, a red organic light-emitting layer R-EML, and a green organic light-emitting layer G-EML can be formed through an in-line deposition system without using a separate deposition pattern mask such as FMM. Accordingly, since a separate deposition pattern mask such as FMM is not used, a high-precision (e.g., 500 PPI or higher) display or a large-area (e.g., $8^{th}$ generation or higher) display can be implemented. Since a separate deposition pattern mask such as FMM is not used, manufacturing costs can be significantly reduced. Since a separate deposition pattern mask such as FMM is not used, yield can be improved and product lifespan can be extended through optimization of deposition.

Meanwhile, as shown in FIGS. 5 to 8 and 10B, the size of the average wall angle θa of the substrate 101 and the three-dimensional structures 130-1 and 130-2 can be determined depending on the selection of materials for the three-dimensional structures 130-1 and 130-2, the equipment or process conditions for forming the three-dimensional structures 130-1 and 130-2. In order to ensure uniform image quality within the screen to prevent color unevenness, the manufacturing method or process conditions for uniformly forming the shapes of the three-dimensional structures 130-1 and 130-2 or the side surfaces 130-1a, 130-1b, 130-2a and 130-2b of the three-dimensional structures 130-1 and 130-2 needs to be optimized.

The angles of the side surfaces 130-1a, 130-1b, 130-2a and 130-2b of the three-dimensional structures 130-1 and 130-2 and the anode electrodes 141g, 141r and 141b with respect to the substrate 101 can affect the formation of organic light-emitting elements 142G, 142R, and 142B and can affect the final image quality. Therefore, selection of this angle can be a key success factor (KSF) in the process and product design stages.

Meanwhile, as shown in FIG. 10B, the deposition angle θe of the green organic light-emitting material discharged from the third evaporation source 253 can be expressed by Equation 1. The structure of the third evaporation source 253 can vary depending on the design of the deposition angle θe.

[Equation 1]

$$\tan\theta e = \frac{TS}{offset}$$

The deposition angle θe can be an angle for depositing the green organic light-emitting material only in a specific area of the first three-dimensional structure 130-1 or the second three-dimensional structure 130-2 using the shadow effect caused by the first three-dimensional structure 130-1 or the second three-dimensional structure 130-2 on the substrate 101.

TS can represent the distance between the substrate 101 and the third evaporation source 253, and Offset can represent the shortest distance at which the green organic light-emitting material discharged from the third evaporation source 253 is deposited on the substrate 101.

Equation 1 can be equally applied to the deposition angle of the red organic light-emitting material discharged from the second evaporation source 252.

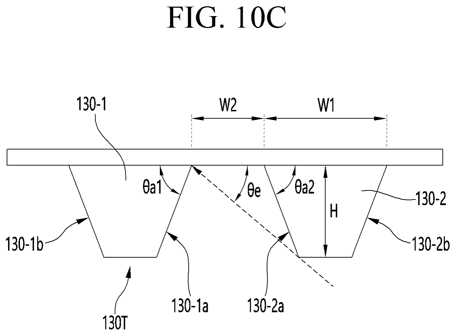

Meanwhile, as shown in FIG. 10C, the deposition angle θe θe for receiving the green organic light-emitting material discharged from the third evaporation source 253 in a specific area of the first three-dimensional structure 130-1 or the second three-dimensional structure 130-2 on the substrate 101 can be expressed as Equation 2. The structure of the pixel P on the substrate 101 can vary depending on the design of the deposition angle θe.

[Equation 2]

$$\tan\theta e = \frac{H}{(0.5W1 + W2)}$$

W1 can represent the width of the first three-dimensional structure 130-1 or the second three-dimensional structure 130-2, W2 can represent the width of the separation region 105, and H can represent the height of the first three-dimensional structure 130-1 or the second three-dimensional structure 130-2.

From Equation 2, the maximum deposition angle θe can increase as the height H of the first three-dimensional structure 130-1 or the second three-dimensional structure 130-2 increases. From Equation 2, as the width W1 of the first three-dimensional structure 130-1 or the second three-dimensional structure 130-2 or the width W2 of the separation region 105 becomes smaller, the maximum deposition angle θe can increase.

Equation 2 can be equally applied to the deposition angle of the red organic light-emitting material discharged from the second evaporation source 252.

Meanwhile, as shown in FIG. 10B, the blue organic light-emitting material discharged from the first evaporation source 251 can be deposited on the entire area of the substrate 101 to form a blue organic light-emitting layer B-EML.

The thickness of the blue organic light-emitting layer B-EML can vary in the blue subpixel SPb, the green subpixel SPg, and the red subpixel SPr. That is, the thickness of the blue organic light-emitting layer B-EML can vary in the blue subpixel SPb, the green subpixel SPg, and the red subpixel SPr depending on the average wall angle θa.

In theory, when the average wall angle θa is 90 degrees, that is, when the green subpixel SPg or the red subpixel SPr is perpendicular to the substrate 101, a blue organic light-emitting layer B-EML on the green subpixel SPg or the red subpixel SPr EML may not form. Additionally, if the blue organic light-emitting material discharged from the first evaporation source 251 travels straight at the same angle, the blue organic light-emitting layer B-EML may not be formed on the green subpixel SPg or the red subpixel SPr perpendicular to the substrate 101.

However, since the blue organic light-emitting material discharged from the first evaporation source 251 travels straight at different angles, even if the green subpixel SPg or the red subpixel SPr is perpendicular to the substrate 101, a blue organic light-emitting layer B-EML can be formed on the green subpixel SPg or the red subpixel SPr. The thickness of the blue organic emitting layer B-EML can be expressed by Equation 3.

[Equation 3]

$$T_{WS} = T_{BS} \cos(\theta a - \theta b)$$

$T_{WS}$ can represent the thickness of the blue organic light-emitting layer B-EML formed on the green subpixel SPg or the red subpixel SPr. $T_{BS}$ can represent the thickness of the blue organic light-emitting layer B-EML formed on the blue subpixel SPb. θa can represent the average wall surface value, and θb can represent a correction angle considering the structure of the first evaporation source 251, especially the evaporation characteristics.

The smaller the correction angle θb, the smaller the thickness $T_{WS}$ of the blue organic light-emitting layer B-EML formed on the green subpixel SPg or the red subpixel SPr. For example, when the correction angle θb is 0, the thickness $T_{WS}$ of the blue organic light-emitting layer B-EML formed on the green subpixel SPg or the red subpixel SPr can be 0. This can mean that the blue organic light-emitting layer B-EML is not formed on the green subpixel SPg or the red subpixel SPr.

For example, when the green subpixel SPg or the red subpixel SPr is perpendicular to the substrate 101 and the correction angle θb is about 10 degrees, the thickness of the blue organic light-emitting layer B-EML formed on the green subpixel SPg and/or the red subpixel SPr can be 17.4% of the thickness of the blue organic light-emitting layer B-EML formed on the blue subpixel SPb. In this case, when the thickness of the blue organic light-emitting layer B-EML formed on the blue subpixel SPb is 20 nm, the thickness of the blue organic light-emitting layer B-EML formed on the green subpixel SPg and/or red subpixel SPr is 3.5 nm, so that it can be ignored. In other words, even if the 3.5 nm blue organic light-emitting layer B-EML is formed on the green subpixel SPg and/or the red subpixel SPr, it does not affect the luminance of the green light emitted from the green subpixel SPg or the red light emitted from the red subpixel SPr.

According to the embodiment, since the blue organic light-emitting layer EML is deposited on the entire area of the substrate 101, there is no need to use a deposition pattern mask such as FMM to deposit it only on a specific area thereof.

In addition, as described above, by using the SAD method and the first three-dimensional structure 130-1 and the second three-dimensional structure 130-2, only the green organic emission layer G-EML can be formed in the green subpixel SPg and only the red organic emission layer R-EML can be formed in the red subpixel SPr without using a deposition pattern mask such as FMM.

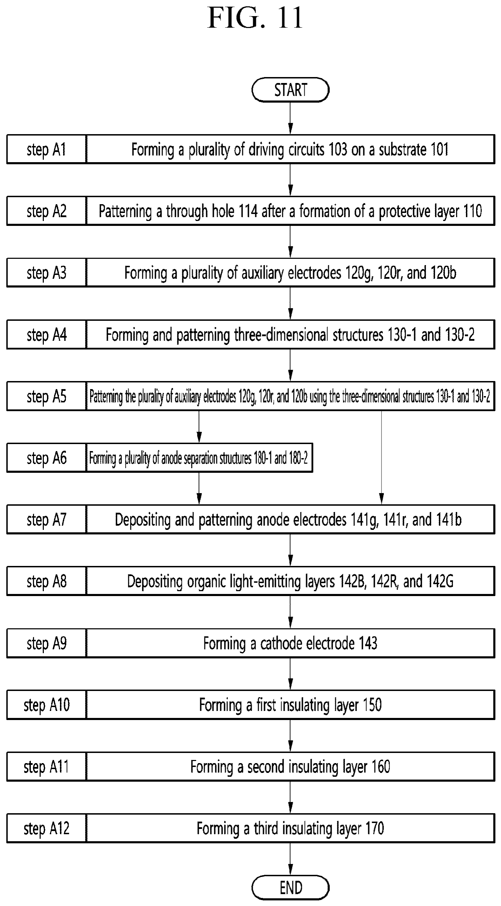

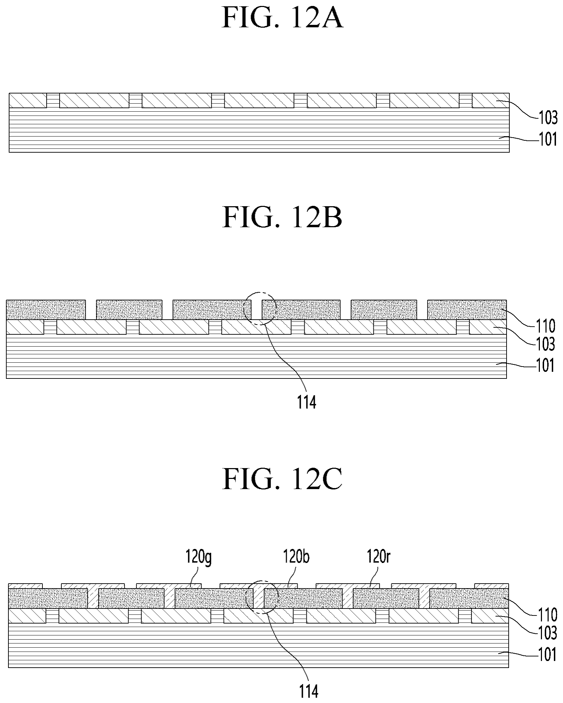

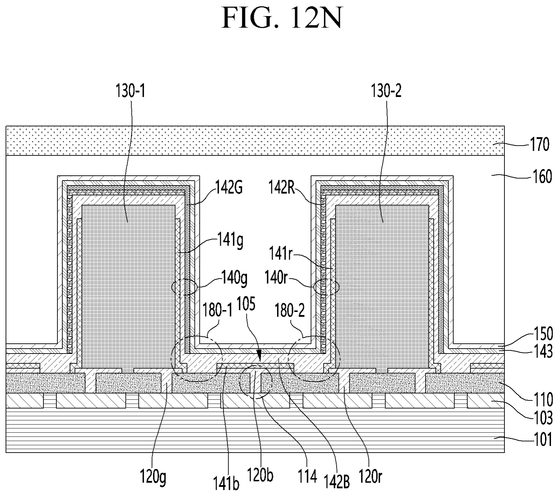

FIG. 11 is a flowchart showing a method of manufacturing an organic light-emitting display device according to a first embodiment. FIGS. 12A to 12N are cross-sectional views showing a method of manufacturing an organic light-emitting display device according to a first embodiment. Using FIGS. 11 to 12N, the manufacturing method of the organic light-emitting display device (FIGS. 7 and 8) having the first three-dimensional structure 130-1 and the second three-dimensional structure 130-2 whose average wall angles θa1 and θa2 are 90 degrees is explained. However, the manufacturing method shown in FIGS. 11 and 12N can be equally applied to the organic light-emitting display device (FIGS. 5 and 6) having the first three-dimensional structure 130-1 and the second three-dimensional structure 130-2 whose average wall angles θa1 and θa2 are less than 90 degrees.

As shown in FIG. 12A, a plurality of driving circuits 103 can be formed on a substrate 101 (step A1).

The plurality of driving circuits 103 can be disposed to be spaced apart from each other. The driving circuit 103 can be formed for each subpixel, but is not limited thereto. The driving circuit 103 can comprise a plurality of transistors and at least one or more capacitor formed using a semiconductor process. The transistor can be formed of a silicon-based semiconductor material or an oxide-based semiconductor material.

As shown in FIG. 12B, after a protective layer 110 is formed on the plurality of driving circuits 103, a through hole 114 can be formed in the protective layer 110 (step A2).

The protective layer 110 can be formed as a single layer or a multilayer made of an inorganic material. The protective layer 110 can comprise a polymer resin layer. The through hole 114 can be formed to penetrate the protective layer 110 to expose a drain electrode of a driving transistor of the driving circuit 103.

For example, when the polymer resin layer is formed on the plurality of driving circuits 103, a first through hole can be formed in the polymer resin layer. Thereafter, after an inorganic film is formed on the polymer resin layer, a second through hole having a larger diameter than the first through hole can be formed in the inorganic film. The second through hole can be connected to the first through hole. The through hole 114 can be formed by the first through hole and the second through hole. In this case, the protective layer 110 can be formed of the polymer resin layer and the inorganic film.

As shown in FIG. 12C, a plurality of auxiliary electrodes 120g, 120r, and 120b can be formed on the protective layer 110 (step A3).

The plurality of auxiliary electrodes 120g, 120r, and 120b can be formed by being deposited and patterned using a sputtering process. The plurality of auxiliary electrodes 120g, 120r, and 120b can be formed for each subpixel. The width of the third auxiliary electrode 120b can be larger than the width of the first auxiliary electrode 120g or the width of the second auxiliary electrode 120r, but is not limited thereto. The plurality of auxiliary electrodes 120g, 120r, and 120b can be disposed to be spaced apart from each other. The plurality of auxiliary electrodes 120g, 120r, and 120b can each vertically overlap the plurality of driving circuits 103. The plurality of auxiliary electrodes 120g, 120r, and 120b can each be electrically connected to the respective drain electrodes of the driving transistors of the plurality of driving circuits 103 through the respective through holes 114 of the protective layer 110.

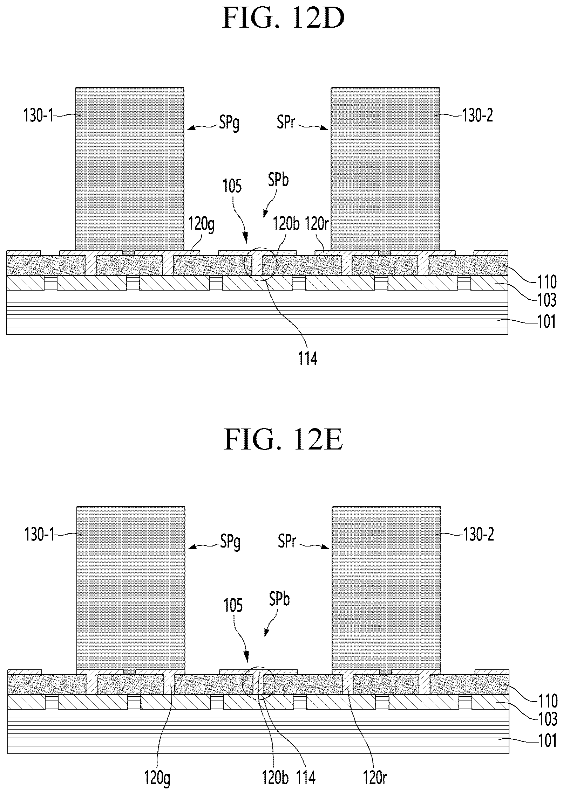

As shown in FIG. 12D, a first three-dimensional structure 130-1 and a second three-dimensional structure 130-2 can be formed on the first auxiliary electrode 120g and the second auxiliary electrode 120r (step A4).

For example, the first three-dimensional structure 130-1 can be formed on the first auxiliary electrode 120g, and the second three-dimensional structure 130-2 can be formed on the second auxiliary electrode 120r. No three-dimensional structure can be formed on the third auxiliary electrode 120b. The third auxiliary electrode 120b can be defined as a separation region 105, but is not limited thereto.

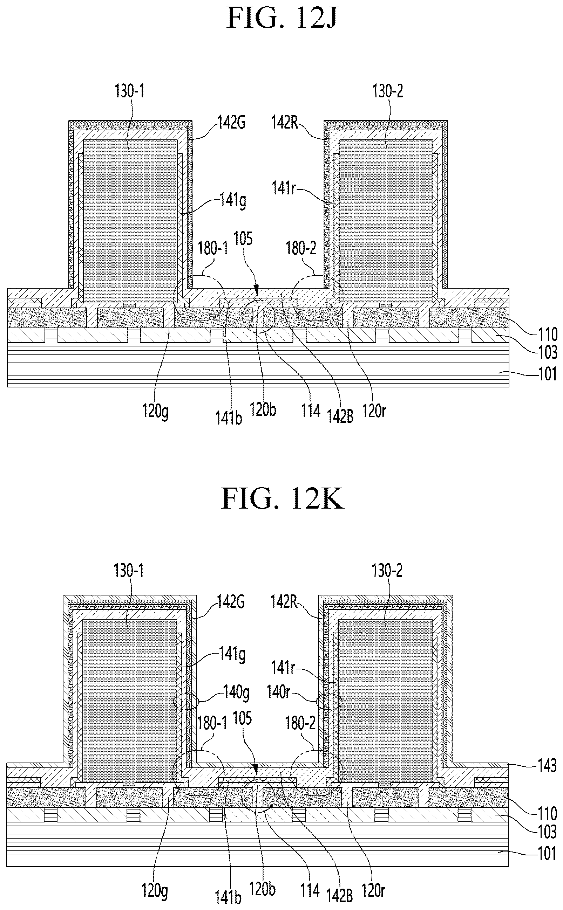

For example, the green subpixel SPg can defined on a first side surface 130-1a of the first three-dimensional structure 130-1, the red subpixel SPr can be defined on a first side surface 130-2a of the second three-dimensional structure 130-2, and the blue subpixel SPb can be defined in the separation region 105. As will be explained later, a green organic light-emitting element (140g in FIG. 12K) can be disposed in the green subpixel SPg, a red organic light-emitting element 140r can be disposed in the red subpixel SPr, and a blue organic light-emitting element 140b can be disposed in the blue subpixel SPb.

The first three-dimensional structure 130-1 and the second three-dimensional structure 130-2 can be made of acrylic or polyimide resin. The first three-dimensional structure 130-1 and the second three-dimensional structure 130-2 can be formed of inorganic materials for high-resolution products. If the resolution of the product is 300 ppi or less, organic materials can be applied to the substrate using printing technology, accurately aligned and transferred to the substrate, and then patterned through ultraviolet rays or thermal curing. Accordingly, the first three-dimensional structure 130-1 and the second three-dimensional structure 130-2 can be formed.

As shown in FIG. 12E, the plurality of auxiliary electrodes 120g, 120r, and 120b can be patterned using the three-dimensional structures 130-1 and 130-2 as masks (step A5).

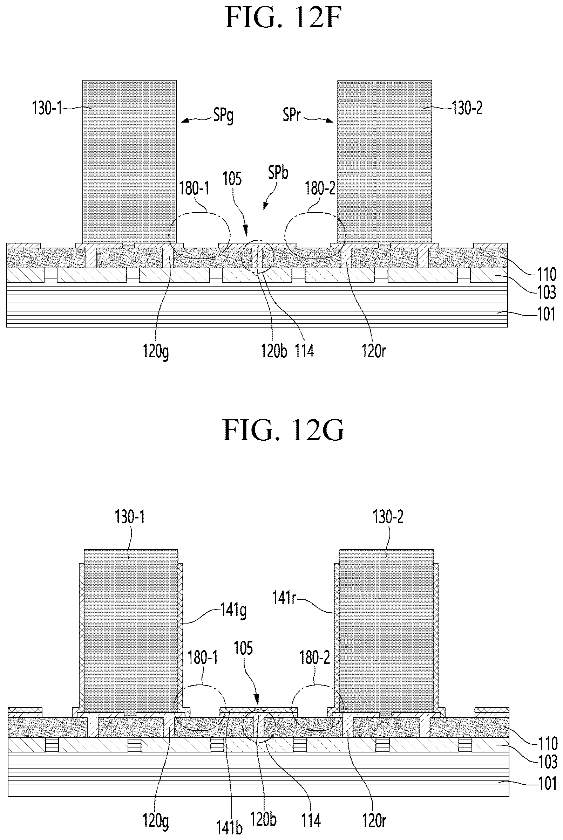

Depending on the type and structure of the auxiliary electrodes 120g, 120b, and 120r or the design value of the anode separation structure (180-1, 180-2 in FIG. 12F), it can be patterned using wet etching, dry etching, or a mixture of the two etchings is used. Additionally, after patterning, an ashing process can be added.

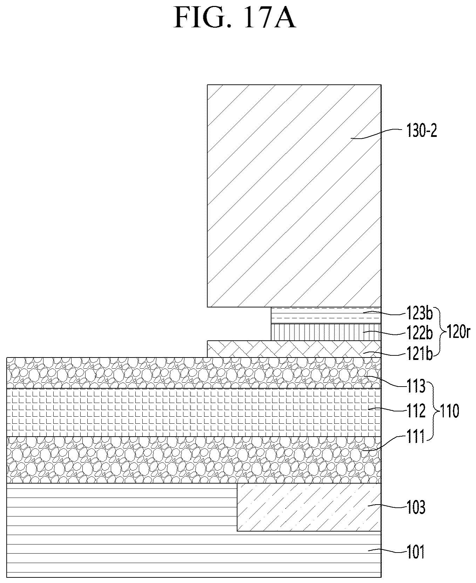

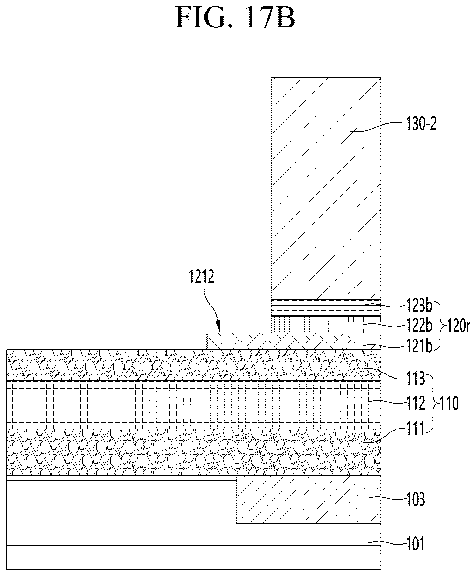

When the auxiliary electrodes 120g, 120b, and 120r are made of a plurality of metal films and the plurality of metal films are patterned, the ends of the plurality of metal films can be positioned differently depending on the materials or etching characteristics of the plurality of metal films. That is, the ends of some of the metal films among the plurality of metal films can protrude further outward than the ends of other metal films. This will be described in detail with reference to FIGS. 17A and 17B.

As shown in FIG. 12F, a plurality of anode separation structures 180-1 and 180-2 can be formed (step A6).

For example, the first anode separation structure 180-1 can be formed along the perimeter of the first three-dimensional structure 130-1, and the second anode separation structure 180-2 can be formed along the perimeter of the second three-dimensional structure 130-2.

The anode separation structure can refer to a plurality of disconnected structures configured to separate with self-alignment and electrically disconnect the anode electrode or charge generation layer CGL using the undercut structure formed in the protective layer 110, but is not limited thereto.

Therefore, the anode electrode can be formed separately for each subpixel SPg, SPr, and SPb without a separate patterning process, thereby simplifying the manufacturing process and reducing manufacturing costs. In addition, defective patterning of the anode electrode at high precision or high resolution can be fundamentally prevented. In addition, the charge generation layer CGL commonly formed in the plurality of subpixels SPg, SPr, and SPb can be disconnected for each subpixel SPg, SPr, and SPb, thereby preventing lateral current leakage between each subpixel.

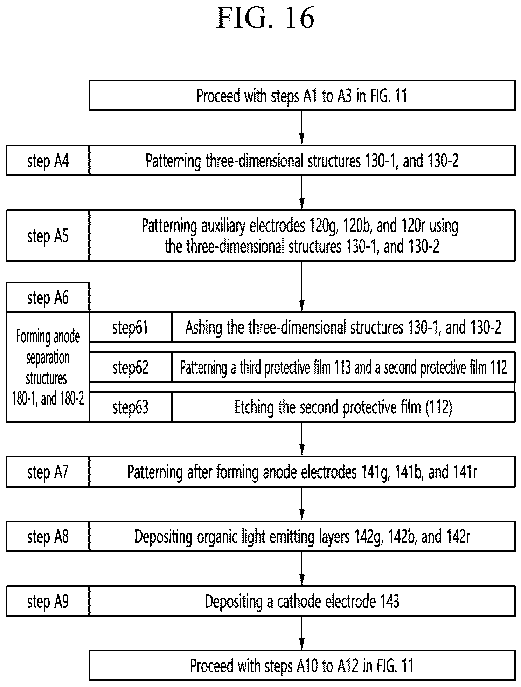

The method of forming the anode separation structure will be described in detail later with reference to FIGS. 16 to 17G.

As shown in FIG. 12G, anode electrodes 141g, 141r, and 141b can be deposited on the substrate 101 provided with the first three-dimensional structure 130-1 and the second three-dimensional structure 130-2. In this case, the anode electrodes 141g, 141r, and 141b can be separated into subpixels SPg, SPr, and SPb by the plurality of anode separation structures 180-1 and 180-2 (step A7). That is, the anode electrodes 141g, 141r, and 141b can be formed only in the corresponding subpixels SPg, SPr, and SPb, and may be not formed between subpixels SPg, SPr, and SPb.

The anode electrodes 141g, 141r, and 141b can comprise a transparent conductive film, but is not limited thereto. The anode electrodes 141g, 141r, and 141b can be a single metal film such as Ni, Au, etc., or can comprise multiple metal films such as Ni/Au. The third auxiliary electrode 120b on the blue subpixel SPb can be made of a multilayer, for example, ITO/Ag alloy/Ti, to ensure reflectance.

Meanwhile, a photoresist pattern can be formed on the first three-dimensional structure 130-1 and the second three-dimensional structure 130-2 before the film forming process so that the anode electrodes 141g, 141r, and 141b may be not formed on the upper surface 130T of each of the first three-dimensional structure 130-1 and the second three-dimensional structure 130-2, but is not limited thereto.

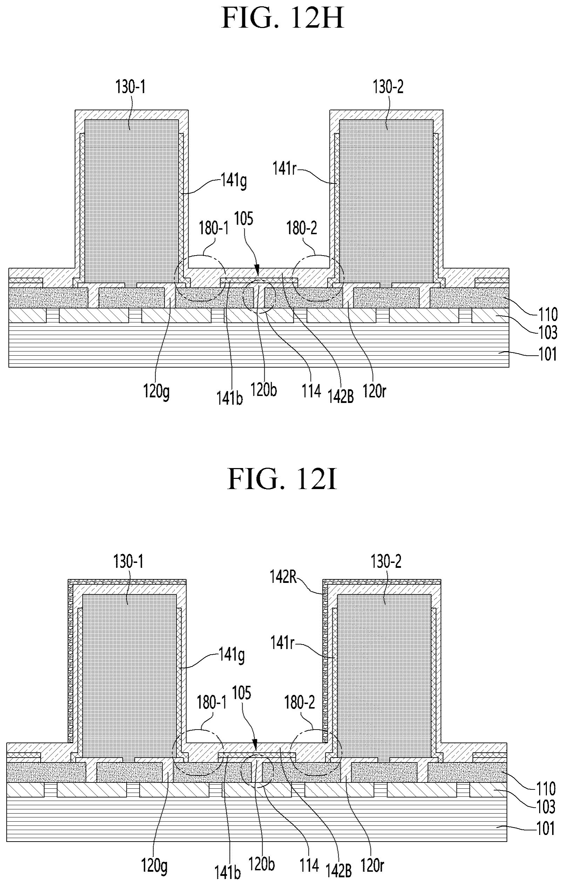

As shown in FIGS. 12H, 12I, and 12J, a blue organic light-emitting layer 142B, a red organic light-emitting layer 142R, and a green organic light-emitting layer 142G can be sequentially deposited on the substrate 101 (step A8).

Specifically, as shown in FIG. 12H, the blue organic light-emitting layer 142B can be deposited on the entire area of the substrate 101 using the first evaporation source (251 in FIG. 10B) of the second chamber (CH2 in FIG. 10A). That is, the blue organic light-emitting layer 142B can be formed in the green subpixel SPg, the red subpixel SPr, and the blue subpixel SPb. The blue organic light-emitting layer 142B can be formed on the anode electrodes 141g, 141r, and 141b in the green subpixel SPg, the red subpixel SPr, and the blue subpixel SPb. In addition, before the blue organic light-emitting layer 142B is formed, a hole injection layer HIL and a hole transport layer HTL can be formed on the anode electrodes 141g, 141r, and 141b using each evaporation source of the first chamber CH1.

Even if the hole injection layer HIL, the hole transport layer HTL, and the blue organic light-emitting layer 142B are deposited on the entire area of the substrate 101, the hole injection layer HIL, the hole transport layer HTL, and the blue organic light-emitting layer 142B can be disconnected and separated between the green subpixel SPg, the red subpixel SPr, and the blue subpixel SPb by the first anode separation structure 180-1 and the second anode separation structure 180-2.

In order to prevent defects such as color purity and color unevenness, it is very important to manage the thickness of the blue organic light-emitting layer 142B on the green subpixel SPg or red subpixel SPr. The green subpixel SPg can emit green light, the red subpixel SPr can emit red light, and the blue subpixel SPb can emit blue light. In this case, since the blue organic light-emitting layer 142B on the green subpixel SPg or red subpixel SPr interferes with the emission of green light or red light, it is desirable to remove.

However, as shown in Equation 3, even if the side surfaces 130-1a and 130-1b of the first three-dimensional structure 130-1 or the side surfaces 130-2a and 130-2b of the second three-dimensional structure 130-2 are perpendicular to the substrate 101, since the blue organic light-emitting material discharged from the first evaporation source 251 travels straight at different angles, the blue organic light-emitting layer 142B is likely to be formed on the green subpixel SPg or the red subpixel SPr. In the embodiment, the structure of the first evaporation source 251, especially the correction angle $\theta b$ considering the evaporation characteristics, is minimized to reduce the thickness of the blue organic light-emitting layer 142B formed on the green subpixel SPg or the red subpixel SPr. Even if the blue organic light-emitting layer 142B is formed on the green subpixel SPg or the red subpixel SPr, the thickness of the blue organic light-emitting layer 142B can be managed so as not to affect the luminance of the color light emitted from the green subpixel SPg or the red subpixel SPr.

To this end, the average wall angle θa can be optimized within the range of 60 degrees to 90 degrees, so that the thickness of the blue organic emission layer 142B on the green subpixel SPg or the red subpixel SPr can be managed to be 5% to 60% of the thickness of the blue organic emission layer 142B formed on the blue subpixel SPb.

As shown in FIG. 12I, a red organic light-emitting layer 142R can be deposited on the substrate 101. The red organic light-emitting layer 142R can be deposited on the first side surface 130-2a of the second three-dimensional structure 130-2 using the second evaporation source (252 in FIG. 10B) of the third chamber (CH3 in FIG. 10A). The red organic light-emitting layer 142R can be deposited on the second side surface 130-1b of the first three-dimensional structure 130-1 and the blue organic light-emitting layer 142B on the first side surface 130-2a of the second three-dimensional structure 130-2. At this time, due to the shadow effect in which the first three-dimensional structure 130-1 and the second three-dimensional structure 130-2 act as a screen, the red organic light-emitting material may be not formed on the first side surface 130-1a of the first three-dimensional structure 130-1, the second side surface 130-2b of the second three-dimensional structure 130-2, and the spaced area 105.

Therefore, without using a deposition pattern mask such as FMM and using the SAD method, the red organic emission layer 142R can be selectively deposited on a specific area, that is, on the second side surface 130-1b of the first three-dimensional structure 130-1 or the first side surface 130-2a of the second three-dimensional structure 130-2.

As shown in FIG. 12J, a green organic light-emitting layer 142G can be deposited on the substrate 101. The green organic light-emitting layer 142G can be deposited on the first side surface 130-1a of the first three-dimensional structure 130-1 using the third evaporation source (253 in FIG. 10B) of the fourth chamber (CH4 in FIG. 10A). The green organic light-emitting layer 142G can be deposited on the blue organic light-emitting layer 142B on the first side surface 130-1a of the first three-dimensional structure 130-1 and the second side surface 130-2b of the second three-dimensional structure 130-2. At this time, due to the shadow effect in which the first three-dimensional structure 130-1 and the second three-dimensional structure 130-2 serve as a screen, the green organic light-emitting material may be not formed on the second side surface 130-1b of the first three-dimensional structure 130-1, the first side surface 130-2a of the second three-dimensional structure 130-2, and the spaced area 105.

Therefore, without using a deposition pattern mask such as FMM and using the SAD method, the green organic emission layer 142G can be selectively deposited on a specific area, that is, on the first side surface 130-1a of the first three-dimensional structure 130-1 or the second side surface 130-2b of the second three-dimensional structure 130-2.

Thereafter, an electron transport layer ETL and an electron injection layer EIL can be formed using each evaporation source of the fifth chamber CH5 and the sixth chamber CH6.

As shown in FIG. 12K, a cathode electrode 143 can be formed on the organic light-emitting layer 142 (step A9). The cathode electrode 143 can be formed by sputtering a transparent conductive film such as ITO or IZO using a sputtering process. The cathode electrode 143 can be formed by depositing a metal film such as magnesium Mg or silver Ag using a vacuum deposition method.

The cathode electrode 143 can be commonly connected to a plurality of subpixels SPg, SPr, and SPb. The cathode electrode 143 must not be disconnected by the anode separation structures 180-1 and 180-2. In the case of vacuum deposition, step coverage of the cathode electrode 143 is not good and then the deposition angle of the evaporation source needs to be optimized so that the cathode electrode 143 is not disconnected by the anode separation structures 180-1 and 180-2. In addition, disconnection of the cathode electrode 143 can be prevented by ensuring that the undercut structure included in the anode separation structures 180-1 and 180-2 does not exceed a predetermined height.

Meanwhile, through the deposition process shown in FIGS. 12G to 12K, a green organic light-emitting element 140g, a red organic light-emitting element 140r, and a blue organic light-emitting element 140b can be formed in each of the green subpixel SPg, the red subpixel SPr, and the blue subpixel SPb. The green organic light-emitting element 140g can comprise the green organic light-emitting layer 142G, the red organic light-emitting element 140r can comprise the red organic light-emitting layer 142R, and the blue organic light-emitting element 140b can comprise the blue organic light-emitting layer 142B. The first anode electrode 141g, the second anode electrode 141r, and the third anode electrode 141b can be independently included in the green organic light-emitting element 140g, the red organic light-emitting element 140r, and the blue organic light-emitting element 140b, respectively, and the cathode electrode 143 can be commonly included in the green organic light-emitting element 140g, the red organic light-emitting element 140r, and the blue organic light-emitting element 140b.

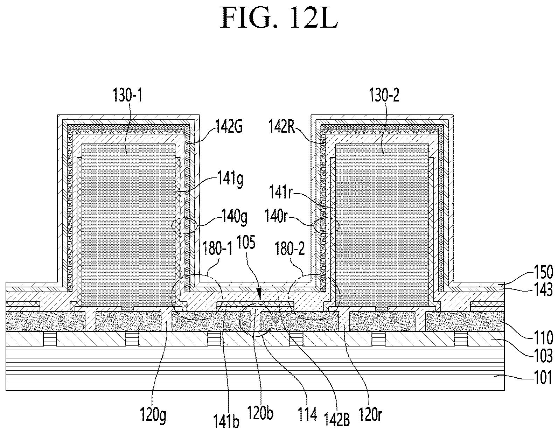

As shown in FIG. 12L, a first insulating layer 150 can be formed on the green organic light-emitting element 140g, the red organic light-emitting element 140r, and the blue organic light-emitting element 140b (step A10).

The first insulating layer 150 can be formed on the cathode electrode 143 of each of the green organic light-emitting element 140g, the red organic light-emitting element 140r, and the blue organic light-emitting element 140b. The first insulating layer 150 can prevent oxygen or moisture from penetrating into the blue organic light-emitting layer 142B, the green organic light-emitting layer 142G, and the blue organic light-emitting layer 142B.

The first insulating layer 150 can be made of an inorganic film. For example, the inorganic film can be a silicon oxide film or a silicon nitride film formed by the PECVD method. The first insulating layer 150 can comprise films (e.g., a SiNx film, a SiOx film, or an $Al_2O_3$ film) formed using an atomic layer deposition (ALD) method. The first insulating layer 150 can comprise a double layer of a film formed using the ALD method and a film formed using a PECVD method. The first insulating layer 150 can comprise a double layer of a film formed using a PECVD method on top of films formed using the ALD method.

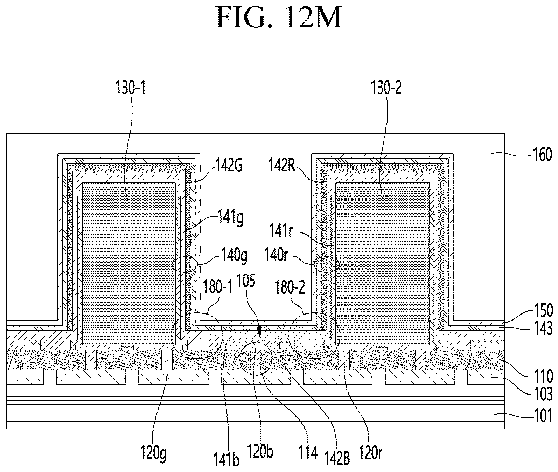

As shown in FIG. 12M, a second insulating layer 160 can be formed on the first insulating layer 150 (step A11).

The second insulating layer 160 can be formed on the first insulating layer 150 between the first three-dimensional structure 130-1 and the second three-dimensional structure 130-2. The second insulating layer 160 can be made of an organic material that can easily form a large thickness, but is not limited thereto. The second insulating layer 160 can be formed using an inkjet method, but is not limited thereto.

As shown in FIG. 12N, a third insulating layer 170 can be formed on the second insulating layer 160 (step A12).

The third insulating layer 170 can be made of an inorganic film. The third insulating layer 170 can be formed of the same material as the first insulating layer 150, but is not limited thereto.

The organic light-emitting display device (third embodiment) shown in FIG. 7 can be manufactured by the manufacturing method shown in FIGS. 12A to 12N.

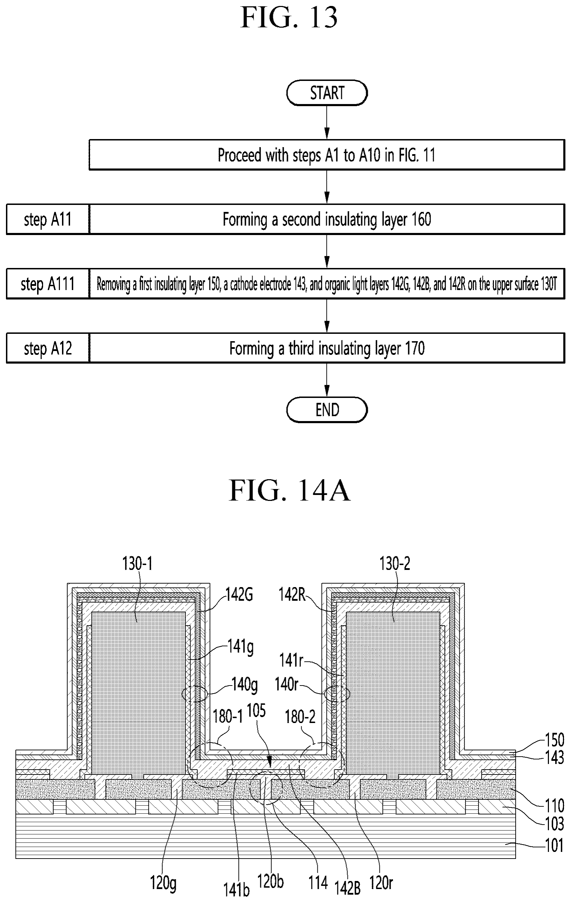

FIG. 13 is a flowchart showing a method of manufacturing an organic light-emitting display device according to a second embodiment. FIGS. 14A to 14D are cross-sectional views showing a method of manufacturing an organic light-emitting display device according to a second embodiment.

The manufacturing method of the image display device (FIGS. 7 and 8) having a first three-dimensional structure 130-1 and a second three-dimensional structure 130-2 with average wall angles $\theta a1$ and $\theta a2$ of 90 degrees will be described using FIGS. 13 to 14D. However, the manufacturing method shown in FIGS. 13 to 14D can be equally applied to the video display device (FIGS. 5 and 6) having a first three-dimensional structure 130-1 and a second three-dimensional structure 130-2 with average wall angles $\theta a1$ and $\theta a2$ of less than 90 degrees.

Since steps A1 to A10 in FIG. 13 are the same as steps A1 to A10 shown in FIGS. 11 to 12L, detailed description is omitted.

As shown in FIG. 14A, a first insulating layer 150 can be formed on a green organic light-emitting element 140g, a red organic light-emitting element 140r, and a blue organic light-emitting element 140b (step A10).

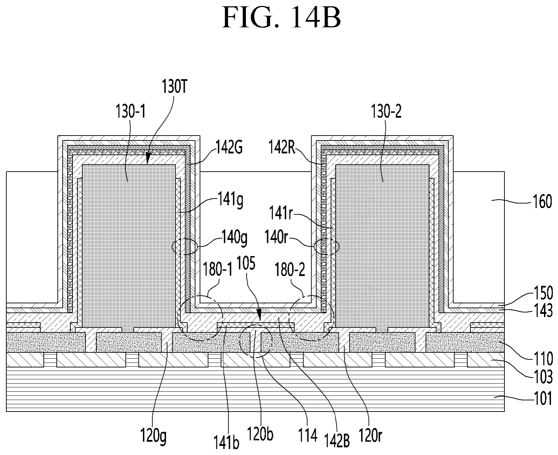

As shown in FIG. 14B, a second insulating layer 160 can be formed on the first insulating layer 150 (step A11).

The second insulating layer 160 can be formed on the first insulating layer 150 between the first three-dimensional structure 130-1 and the second three-dimensional structure 130-2.

Unlike FIG. 12M, the upper surface of the second insulating layer 160 shown in FIG. 14B can be located at least lower than the upper surface 130T of the first three-dimensional structure 130-1 or the second three-dimensional structure 130-2. The upper surface of the second insulating layer 160 can be positioned higher than the upper end of the first anode electrode 141g on the first side surface 130-1a of the first three-dimensional structure 130-1. The upper surface of the second insulating layer 160 can be positioned higher than the upper end of the second anode electrode 141r on the first side surface 130-2a of the second three-dimensional structure 130-2.

For this purpose, in the case of an inkjet process, the amount of dotting and the amount of shrinkage after vacuum dry can be considered. Additionally, a material that takes into account the surface energy between the first insulating layer 150 and the second insulating layer 160 can be selected.

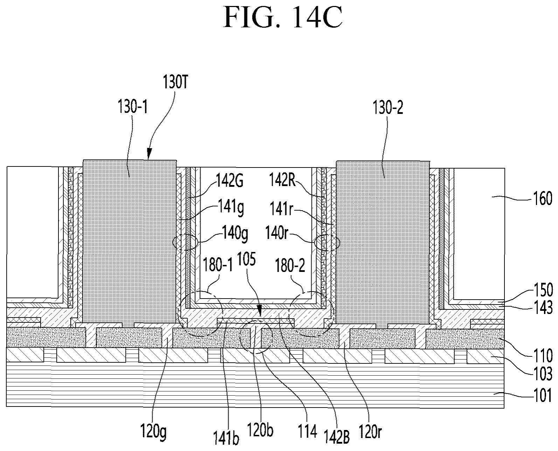

As shown in FIG. 14C, the first insulating layer 150, a cathode electrode 143, a green organic light-emitting layer 142G, a red organic light-emitting layer 142R, and a blue organic light-emitting layer 142B on the upper surface 130T of each of the first three-dimensional structure 130-1 and the second three-dimensional structure 130-2 can be removed ( Step A111).

In the dry etching process, the amount of ashing and the selection of possible gas for each material are important, and damage to the blue organic light-emitting elements 140b should not occur in the dry etching process.

When removing the first insulating layer 150, the cathode electrode 143, etc., a second insulating layer 160 can be used as a stopper. That is, the first insulating layer 150, the cathode electrode 143, the green organic light-emitting layer 142G, the red organic light-emitting layer 142R, and the blue organic light-emitting layer 142B can each be removed up to the upper surface of the second insulating layer.

By removing the first insulating layer 150, the cathode electrode 143, the green organic light-emitting layer 142G, the red organic light-emitting layer 142R, and the blue organic light-emitting layer 142B, which are higher than the upper surface of the second insulating layer, the upper surface 130T of each of the first three-dimensional structure 130-1 or the second three-dimensional structure 130-2 can be exposed. Accordingly, lateral current leakage between the green subpixel SPg on the first side surface 130-1a of the first three-dimensional structure 130-1 and the red subpixel SPr on the second side surface 130-1b can be prevented. Lateral current leakage between the red subpixel SPr on the first side surface 130-2a of the second three-dimensional structure 130-2 and the green subpixel SPg on the second side surface 130-2b can be prevented. In particular, in the two-stack tandem structure, the charge generation layer on the upper surface 130T of the first three-dimensional structure 130-1 or the second three-dimensional structure 130-2 can be removed, so that the lateral current leakage between the green subpixel SPg and the red subpixel SPr can be prevented through the charge generation layer.

At least one or more of the removed and remaining first insulating layer 150, the cathode electrode 143, the green organic light-emitting layer 142G, the red organic light-emitting layer 142R, and the blue organic light-emitting layer 142B can be located lower than the upper surface 130T of each of the first three-dimensional structure 130-1 and the second three-dimensional structure 130-2. With this structure, the organic light-emitting layers 142G, 142R, and 142B on adjacent subpixels SPg and SPr can be completely disconnected, so that lateral current leakage can be more reliably prevented.

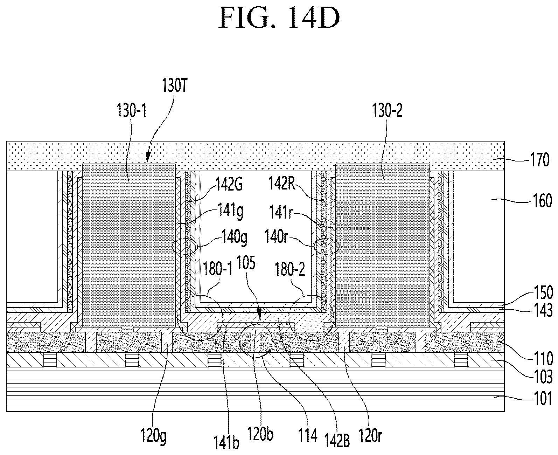

As shown in FIG. 14D, a third insulating layer 170 can be formed on the substrate 101 (step A12).

The third insulating layer can be formed on the second insulating layer 160 between the first three-dimensional structure 130-1 and the second three-dimensional structure 130-2. The third insulating layer 170 can be formed on the exposed upper surface 130T of each of the first three-dimensional structure 130-1 and the second three-dimensional structure 130-2.

Not only is the organic light-emitting layer between the adjacent subpixels SPg and SPr completely disconnected from the upper surface 130T of each of the first three-dimensional structure 130-1 and the second three-dimensional structure 130-2, but the third insulating layer 170 is in contact with the upper surface 130T of each of the first three-dimensional structure 130-1 and the second three-dimensional structure 130-2, lateral current leakage can be more completely prevented.

The organic light-emitting display device (fourth embodiment) shown in FIG. 8 can be manufactured by the manufacturing method shown in FIGS. 14A to 14D.

Meanwhile, as shown in FIG. 14C, lateral current leakage can be prevented without removing all of the layers on the upper surfaces of each of the first three-dimensional structure 130-1 and the second three-dimensional structure 130-2, such as the second insulating layer 160, the first insulating layer 150, the green organic light-emitting layer 142G, the red organic light-emitting layer 142R, and the blue organic light-emitting layer 142B.

Specifically, as shown in FIG. 12M, the second insulating layer 160 can be formed on the first insulating layer 150. Thereafter, the second insulating layer 160, the first insulating layer 150, the green organic light-emitting layer 142G, the red organic light-emitting layer 142R, and the blue organic light-emitting layer 142B can be locally removed on the upper surfaces of each of the first three-dimensional structure 130-1 and the second three-dimensional structure 130-2, so that the upper surfaces of each of the first three-dimensional structure 130-1 and the second three-dimensional structure 130-2 can be exposed. Accordingly, the second insulating layer 160, the first insulating layer 150, the green organic light-emitting layer 142G, the red organic light-emitting layer 142R and the blue organic light-emitting layer 142B can have a structure that is separated from each other on the upper surfaces of each of the first three-dimensional structure 130-1 and the second three-dimensional structure 130-2. Accordingly, the path through which leakage current flows between the green subpixel SPg and the red subpixel SPr on the upper surfaces of each of the first three-dimensional structure 130-1 and the second three-dimensional structure 130-2 can be removed, thereby preventing lateral current leakage.

According to the embodiment, the leakage current paths between all subpixels SPg, SPr and SPb can be blocked by the anode separation structures 180-1 and 180-2 and the separation structures on the three-dimensional structures 130-1 and 130-2, so that lateral leakage current can be completely prevented.

Afterwards, the third insulating layer 170 can be formed on the second insulating layer 160. In this case, the third insulating layer 170 can be in contact with the etched cross sections of each of the second insulating layer 160, the first insulating layer 150, the green organic light-emitting layer 142G, the red organic light-emitting layer 142R, and the blue organic light-emitting layer 142B, and can be in contact with the upper surface of the first three-dimensional structure 130-1 and the upper surface of the second three-dimensional structure 130-2. The green organic light-emitting layer 142G, the red organic light-emitting layer 142R, and the blue organic light-emitting layer 142B can each have a structure in which they are separated by a third insulating layer 170.

FIG. 15 is a detailed cross-sectional view of area X in FIG. 7. The first anode separation structure 180-1 and the second anode separation structure 180-2 will be described in detail with reference to FIG. 15.

As shown in FIG. 15, the green subpixel SPg can be defined on the first side surface 130-1a of the first three-dimensional structure 130-1, and the red subpixel SPr can be defined on the first side surface 130-2a of the second three-dimensional structure 130-2, and the blue subpixel SPb can be defined on the separation region 105. The green subpixel SPg can comprise a green organic light-emitting element 140g, the red subpixel SPr can comprise a red organic light-emitting element 140r, and the blue subpixel SPb can comprise a blue organic light-emitting element 140b. One pixel P can be composed of the green subpixel SPg, the red subpixel SPr, and the blue subpixel SPb.

The first anode separation structure 180-1 can be disposed along the perimeter of the first three-dimensional structure 130-1. The first anode separation structure 180-1 can be disposed in the lower side of the first three-dimensional structure 130-1 between the green subpixel SPg and the blue subpixel SPb. The first anode separation structure 180-1 can be disposed in the lower side of the first three-dimensional structure 130-1 between the green organic light-emitting element 140g and the blue organic light-emitting element 140b.

The first anode separation structure 180-1 can comprise a first undercut structure 1810 and a first disconnection structure 1820.

The first undercut structure 1810 can be formed such that the end of at least one or more insulating film 112 among the plurality of insulating films 111 to 113 constituting the protective layer 110 is positioned inside from the first side surface 130-1a of the first three-dimensional structure 130-1.

The first disconnection structure 1820 can disconnect the green subpixel SPg and the blue subpixel SPb by the first undercut structure 1810. The first disconnection structure 1820 can comprise a first-first disconnection structure 1821, a first-second disconnection structure 1822, a first-third disconnection structure 1823, etc.

The disconnection structure 1821 can disconnect the first anode electrode 141g of the green organic light-emitting element 140g and the third anode electrode 141b of the blue organic light-emitting element 140b between the green subpixel SPg and the blue subpixel SPb. During the anode electrode formation process, at least one or more metal film can be formed on the substrate 101. In this case, at least one or more metal film can be disconnected between the green subpixel SPg and the blue subpixel SPb by the first undercut structure 1810. Accordingly, the first anode electrode 141g can be formed in the green subpixel SPg, and the third anode electrode 141b can be formed in the blue subpixel SPb.

Meanwhile, as shown in FIGS. 9A and 9B, a common layer can be formed in the green organic light-emitting element 140g, the red organic light-emitting element 140r, and the blue organic light-emitting element 140b. For example, in FIG. 9A, the common layer can comprise a hole injection layer HIL, a hole transport layer HTL, an electron blocking layer EBL, a blue organic light-emitting layer 142B, a charge generation layer CGL, an electron transport layer ETL, and a cathode electrode 143. For example, in FIG. 9B, the common layer can comprise a hole injection layer HIL, hole transport layers HTL1 and HTL2, electron blocking layers EBL1 and EBL2, a blue organic light-emitting layer 142B, a charge generation layer CGL, electron transport layers ETL1 and ETL2, a cathode electrode 143, etc.

Since the blue organic light-emitting layer 142B or the charge generation layer CGL causes lateral current leakage, it must be disconnected between the green subpixel SPg, the red subpixel SPr, and the blue subpixel SPb. In contrast, the cathode electrode 143 can be electrically connected in common to the green organic light-emitting element 140g, the red organic light-emitting element 140r, and the blue organic light-emitting element 140b, so that it should be not disconnected between the green subpixel SPg, the red subpixel SPr, and the blue subpixel SPb.

According to an embodiment, the blue organic light-emitting layer 142B, the charge generation layer CGL, etc. can be disconnected between the green subpixel SPg and the blue subpixel SPb by the first undercut structure 1810.

The disconnection structure 1822 can disconnect the blue organic light-emitting layer 142B between the green subpixel SPg and the blue subpixel SPb by the first undercut structure 1810 and/or the separation gap between the first anode electrode 141g and the third anode electrode 141b. The first-third disconnection structure 1823 can disconnect the charge generation layer CGL between the green subpixel SPg and the blue subpixel SPb by the first undercut structure 1810, the separation gap between the first anode electrode 141g and the third anode electrode 141b, and/or the disconnected blue organic light-emitting layer 142B.

Accordingly, the blue organic light-emitting layer 142B or the charge generation layer CGL can be disconnected between the green subpixel SPg and the blue subpixel SPb by the first undercut structure 1810, etc., thereby preventing lateral current leakage between each subpixel.

The anode separation structure 180-2 can be disposed along the perimeter of the second three-dimensional structure 130-2. The second anode separation structure 180-2 can be disposed in the lower side of the second three-dimensional structure 130-2 between the red subpixel SPr and the blue subpixel SPb. The second anode separation structure 180-2 can be disposed in the lower side of the second three-dimensional structure 130-2 between the red organic light-emitting element 140r and the blue organic light-emitting element 140b.

The anode separation structure 180-2 can comprise a second undercut structure 1830 and a second disconnection structure 1840.

The second undercut structure 1830 can be formed such that the end of at least one or more insulating film 112 among the plurality of insulating films 111 to 113 constituting the protective layer 110 is positioned inside from the first side surface 130-2a of the second three-dimensional structure 130-2.

The second disconnection structure 1840 can disconnect the red subpixel SPr and the blue subpixel SPb by the second undercut structure 1830. The second disconnection structure 1840 can comprise a second-first disconnection structure 1841, a second-second disconnection structure 1842, a second-third disconnection structure 1843, etc.

The second-first disconnection structure 1841 can disconnect the second anode electrode 141r of the red organic light-emitting element 140r and the third anode electrode 141b of the blue organic light-emitting element 140b between the red subpixel SPr and the blue subpixel SPb. During the anode electrode formation process, at least one or more metal film can be formed on the substrate 101. In this case, at least one or more metal film can be disconnected between the red subpixel SPr and the blue subpixel SPb by the second undercut structure 1830. Accordingly, the second anode electrode 141r can be formed in the green subpixel SPg, and the third anode electrode 141b can be formed in the blue subpixel SPb.

According to an embodiment, the common layer, such as the blue organic light-emitting layer 142B, the charge generation layer CGL, etc. can be disconnected between the red subpixel SPr and the blue subpixel SPb by the second undercut structure 1830.

The second-second disconnection structure 1842 can disconnect the blue organic light-emitting layer 142B between the red subpixel SPr and the blue subpixel SPb By the second undercut structure 1830 and/or the separation gap between the second anode electrode 141r and the third anode electrode 141b. The second-third disconnection structure 1843 can disconnect the charge generation layer CGL between the red subpixel SPr and the blue subpixel SPb by the second undercut structure 1830, the separation gap between the second anode electrode 141r and the third anode electrode 141b and/or the disconnected blue organic light-emitting layer 142B.

Accordingly, the blue organic light-emitting layer 142B or the charge generation layer CGL can be disconnected between the red subpixel SPr and the blue subpixel SPb by the second undercut structure 1830, etc., thereby preventing lateral current leakage between each subpixel.

Meanwhile, the first anode separation structure 180-1 can comprise only the first undercut structure 1810, and the second anode separation structure 180-2 can comprise only the second undercut structure 1830. That is, the first disconnection structure 1820 may not be included in the first anode separation structure 180-1, and the second disconnection structure 1840 may not be included in the second anode separation structure 180-2.

Although not shown, a third auxiliary electrode 120b can be disposed below the third anode electrode 141b. The third anode electrode 141b can be removed and the third auxiliary electrode 120b can be in contact with the hole injection layer HIL in FIGS. 9A and 9B. In this case, the third auxiliary electrode 120b can serve as the third anode electrode 141b.

Meanwhile, the first auxiliary electrode 120g, the second auxiliary electrode 120r, and the third auxiliary electrode 120b can comprise a plurality of metal films 121a, 121b, 122a, 122b, 123a, and 123b, respectively.

For example, the first metal films 121a and 121b can be made of a metal material that has excellent electrical contact characteristics with the driving circuit 103 and is easy to dry etch, and can be made of, for example, Ti, Mo, etc. For example, the second metal films 122a and 122b can be made of a metal material that has excellent reflection properties and is easy to wet etch, and be made of, for example, Ag, Ag alloy, Al, etc. For example, the third metal films 123a and 123b can be transparent materials that have low contact resistance with the anode electrodes 141g, 141r, and 141b and have excellent process reliability, and can be made of ITO, IZO, etc. For example, the third metal films 123a and 123b can be made of Mo, MoTi alloy, Ti, etc.

The first auxiliary electrode 120g can be disposed under the first three-dimensional structure 130-1, and the second auxiliary electrode 120r can be disposed under the second three-dimensional structure 130-2.

At least one metal film 121a among the plurality of metal films 121a, 122a, and 123a of the first auxiliary electrode 120g can comprise a first protruding region 1211 that protrudes outward from the first side surface 130-1a of the first three-dimensional structure 130-1 and contacts the first anode electrode 141g. In the first protruding region 1211, the end of one metal layer 121a of the first auxiliary electrode 120g can protrude further outward than the ends of the other metal layers 122a and 123a.

At least one metal film 121b can comprise a second protruding region 1212 that protrudes outward from the first side surface 130-2a of the second three-dimensional structure 130-2 and contacts the second anode electrode 141r among the plurality of metal films 121b, 122b, and 123b of the second auxiliary electrode 120r. In the second protruding region 1212, the end of one metal film 121b of the first auxiliary electrode 120g can protrude further outward than the ends of the other metal films 122b and 123b.

FIG. 16 is a flowchart showing a method of manufacturing an organic light-emitting display device according to a third embodiment. FIGS. 17A to 17G are cross-sectional views showing a method of manufacturing an organic light-emitting display device according to a third embodiment. 17A to 17G show the red subpixel SPr and the blue subpixel SPb in FIG. 15, but the green subpixel SPg can also be applied equally.

Since steps A1 to A4 in FIG. 16 are the same as steps A1 to A4 shown in FIG. 11, detailed description is omitted.

As shown in FIG. 17A, the auxiliary electrode 120r can be patterned using the three-dimensional structure 130-2 (step A5).

Specifically, the protective layer 110 and the auxiliary electrode 120r can be formed on the substrate 101, and the three-dimensional structure 130-2 can be formed on the auxiliary electrode 120r. The protective layer 110 can comprise a plurality of insulating films 111 to 113. The auxiliary electrode can comprise a plurality of metal films 121b, 122b, and 123b.

Afterwards, the auxiliary electrode 120r can be patterned using the three-dimensional structure 130-2 as a mask. In this case, the ends of the plurality of metal films 121b, 122b, and 123b can be positioned differently from each other. The third metal film 123b, the second metal film 122b, and the first metal film 121b can be etched into various cross-sectional shapes depending on the etching characteristics of the material.

For example, while the third metal film and the second metal film can be etched, the first metal film may not be etched. Accordingly, the third metal film and the second metal film can be overetched under the three-dimensional structure 130-2.

Step A6 in FIG. 16 is a step of forming an anode separation structure, and will be described in detail with reference to FIGS. 17B to 17G.

As shown in FIG. 17B, the width or height of the three-dimensional structure 130-2 can be reduced through an ashing process or dry etching (step A61). Accordingly, the overetched third and second metal films can be exposed. The first metal film can comprise a protruding region 1212 that protrudes outward from the side surfaces 130-1a, 130-1b, 130-2a, and 130-2b of the three-dimensional structure 130-2. The protruding region 1212 can protrude within approximately 2 micrometers from the side surfaces 130-1a, 130-1b, 130-2a, and 130-2b of the three-dimensional structure 130-2.

The etched sides 130-1a, 130-1b, 130-2a and 130-2b of each of the third and second metal films of the auxiliary electrode 120r can be positioned on the same vertical line within an error range of approximately several hundred nanometers.

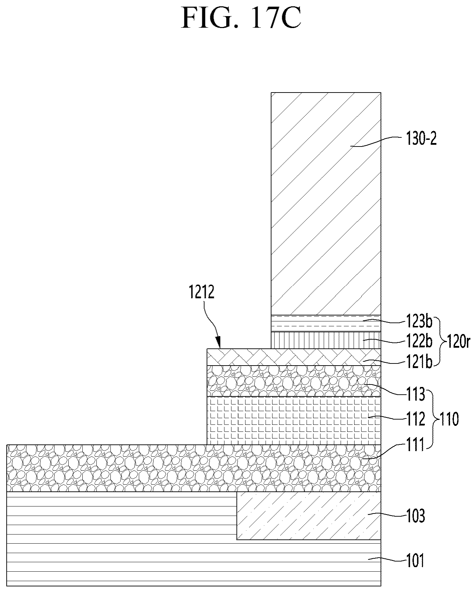

As shown in FIG. 17C, a plurality of insulating films 111 to 113 of the protective layer 110 can be patterned (step A62). For example, dry etching can be performed using the first metal film of the auxiliary electrode 120r as a mask to pattern the third insulating film 113 and the second insulating film 112 of the protective layer 110.

Dry etching characteristics of the first insulating layer 111, the second insulating layer 112, and the third insulating layer 113 can be different. For example, while the dry etching characteristics of the second insulating layer 112 and the third insulating layer 113 are very excellent, the first insulating layer 111 may not be patterned by dry etching. For example, HF series can be used as an etching solution, but is not limited thereto.

For example, the first insulating film 111 and the third insulating film 113 can be a silicon nitride film, and the second insulating film 112 can be a silicon oxide film, but is not limited thereto. In the deposition step of the first insulating film 111, the second insulating film 112, and the third insulating film 113, the ratio of silicon to nitrogen, the ratio of silicon to oxygen, the density of the film, etc. can be optimized, and in the dry etching step, the type and composition ratio of the dry etching gas, etc. can be optimized.

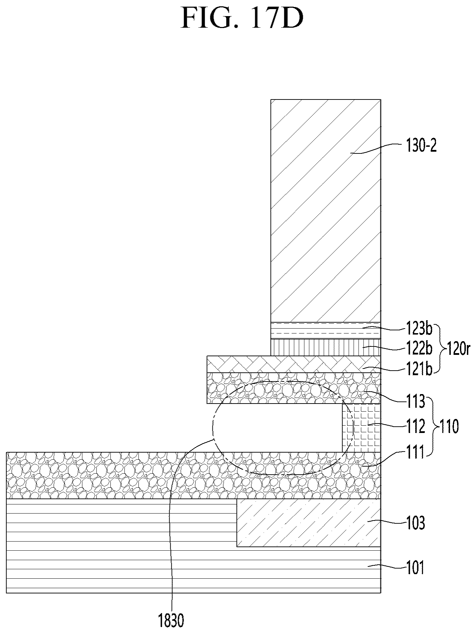

As shown in FIG. 17D, dry etching can be continuously performed to pattern the second insulating layer 112 (step A63). By additional dry etching, the first insulating layer 111 and the third insulating layer 113 may not be patterned, and the second insulating layer 112 can be patterned. Accordingly, an undercut structure 1830 in which the end of the second insulating film 112 is located inside the side surfaces 130-1a, 130-1b, 130-2a, and 130-2b of the three-dimensional structure 130-2 can be formed.

Meanwhile, the third insulating film 113 can be omitted and a double-layer structure of the second insulating film 112 and the first insulating film 111 can be formed. In this case, the first insulating layer 111 can comprise a resin layer, and the second insulating layer 112 can comprise an inorganic layer such as a silicon nitride layer or a silicon oxide layer. Accordingly, the undercut structure 1830 can be easily formed by using the high etch selectivity between the resin film and the inorganic film. When the first insulating film 111 is a resin film, the etching selectivity can be increased to facilitate structure formation by taking advantage of the fact that the resin film is difficult to etch in a wet etching solution.

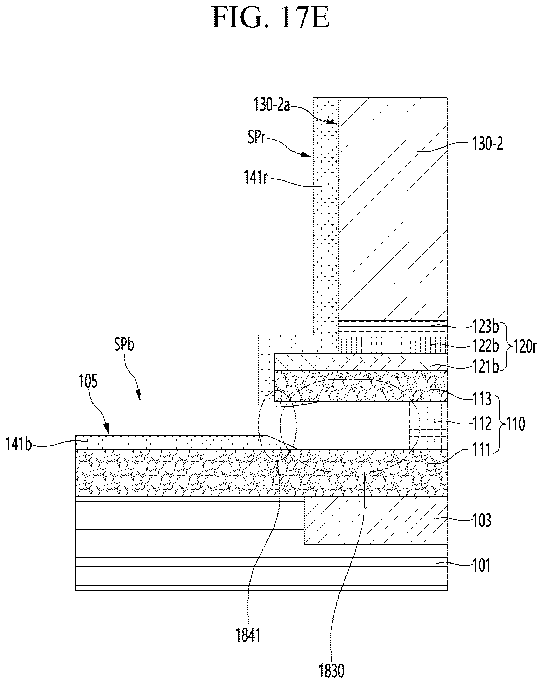

As shown in FIG. 17E, anode electrodes 141r and 141b can be formed on the substrate 101 (step A7). A green anode electrode (142g in FIG. 15) can also be formed on the substrate 101.

At least one or more metal film can be formed on the substrate 101. In this case, the second-first disconnection structure 1841 can be formed by the undercut structure 1830. At least one or more metal film can be disconnected between the red subpixel SPr and the blue subpixel SPb by the second-first disconnection structure 1841 to separate them into a second anode electrode 141r and a third anode electrode 141b. The second anode electrode 141r can be formed in the red subpixel SPr on the side 130-2a of the three-dimensional structure 130-2, and the third anode electrode 141b can be formed on the separation region 105 in the blue subpixel SPb.

Since the thickness of at least one or more metal film is very small, 50 nm or less, the height 182 of the undercut structure 1830 is not reduced by the anode electrodes 141r and 141b, and the anode electrodes 141r and 141b can be prevented from being connected without being separated.

According to the embodiment, the anode electrodes 141r and 141b can be formed separately from each other without an additional process through FMM or the like, so that the manufacturing process can be simplified and the manufacturing cost can be reduced.

Meanwhile, the second anode electrode 141r can be electrically connected to the protruding region 1212 of the first metal film 121b of the auxiliary electrode 120r. That is, the second anode electrode 141r can be in contact with the top and side surfaces of the protruding region 1212 and can be in contact with the side surfaces of each of the second metal film 122b and the third metal film 123b. Accordingly, the contact area between the second anode electrode 141r and the auxiliary electrode 120r can be maximized, and voltage or current supply characteristics can be improved, thereby improving electrical/optical characteristics.

The anode electrode 141b can be removed, and an auxiliary electrode (not shown) located below the third anode electrode 141b can serve as the third anode electrode 141b.

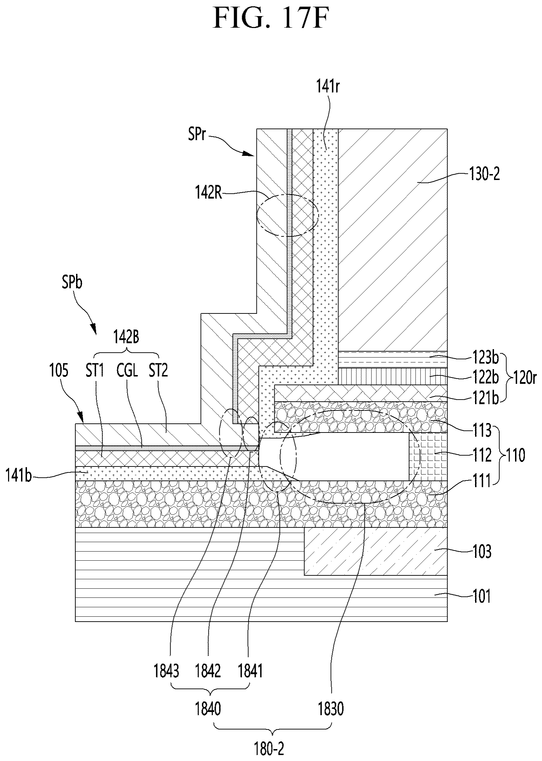

As shown in FIG. 17F, the red organic light-emitting layer 142R and the blue organic light-emitting layer 142B can be deposited on the anode electrodes 141r and 141b (step A8). Although not shown, the green organic light-emitting layer 142G can also be deposited on the green anode electrode (141g in FIG. 15).

The organic light-emitting layer 142R shown in FIG. 17F can be the organic light-emitting layer R-EML1 and R-EML2 of the two-stack structure shown in FIG. 9B.

As shown in FIG. 9B, the red organic light-emitting layer 142R and the blue organic light-emitting layer 142B can have a tandem structure comprising a first stack ST1, a charge generation layer CGL, and a second stack ST2, respectively.

For example, the first stack ST1 of the blue organic light-emitting layer 142B can be deposited on the red subpixel SPr and the blue subpixel SPb, and the first stack ST1 of the red organic light-emitting layer 142R can be deposited on the red subpixel SPr. Afterwards, a charge generation layer CGL can be deposited on the red subpixel SPr and the blue subpixel SPb. Thereafter, the second stack ST2 of the blue organic light-emitting layer 142B can be deposited on the red subpixel SPr and the blue subpixel SPb, and the second stack ST2 of the red organic light-emitting layer 142R can be deposited on the red subpixel SPr.

In this case, a second-second disconnected structure 1842 can be formed in which the first stack ST1 of the blue organic light-emitting layer 142B is disconnected between the red subpixel SPr and the blue subpixel SPb by an undercut structure 1830 or the like. A second-third disconnected structure 1843 can be formed in which the charge generation layer CGL is disconnected between the red subpixel SPr and the blue subpixel SPb by an undercut structure 1830 or the like. The second disconnection structure 1840 can be formed by the second-first disconnection structure 1841, the second-second disconnection structure 1842, and the second-third disconnection structure 1843.

Disconnection of the second anode electrode 141r and the third anode electrode 141b, disconnection of the first stack ST1 of the blue organic light-emitting layer 142B, and disconnection of the charge generation layer CGL can be performed at the same location. That is, these disconnections can be made at a location adjacent to the undercut structure 1830 or on a diagonal line from the undercut structure 1830.

Meanwhile, the organic deposition films constituting the red organic light-emitting layer 142R or the blue organic light-emitting layer 142B have poor step coverage characteristics. However, the embodiment can take advantage of the poor step coverage characteristics of organic deposition films. That is, in the embodiment, since the step coverage characteristics of the organic deposition films are not good, even if the organic deposition films are deposited, the materials of the organic deposition films do not penetrate into the undercut structure 1830. Therefore, since the first stack ST1 of the blue organic light-emitting layer 142B or the charge generation layer CGL is disconnected at the entrance of the undercut structure 1830, image quality can be sharper and luminance can be improved by minimizing the influence of lateral current leakage on adjacent subpixels SPr and SPb.

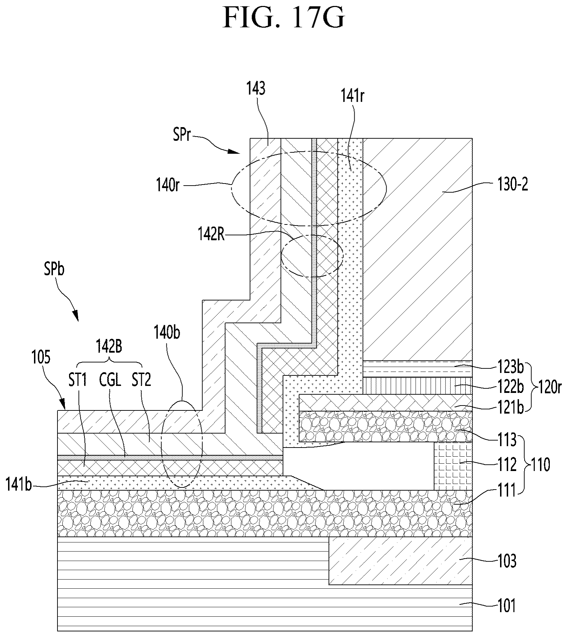

As shown in FIG. 17G, the cathode electrode 143 can be formed (step A9).

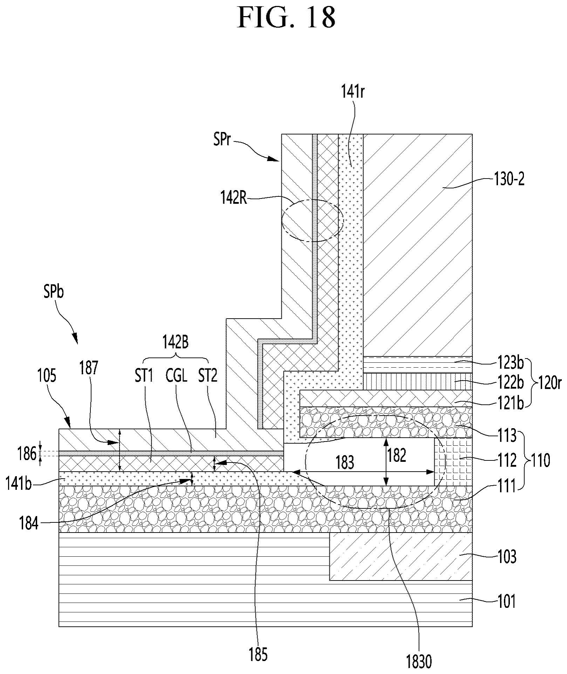

FIG. 18 shows the height and depth of the undercut structure in an anode separation structure according to an embodiment.

As shown in FIG. 18, the cathode electrode 143, which is common to all subpixels (SPg and SPr and SPb in FIG. 15), may be not disconnected (or separated), the second anode electrode 141r and the third anode electrode 141b can be disconnected (or separated) between the red subpixel SPr and the red subpixel SPr, the first blue organic light-emitting layer B-EML1 can be disconnected (or separated), and the charge generation layer CGL can be disconnect (or separate). To obtain these structures, Equation 4 must be satisfied.

Thickness 184 of the third anode electrode 141b + thickness 185 of first stack ST1 + thickness 186 of charge generation layer CGL < height 182 of undercut structure 1830 < thickness 184 of third anode electrode 141b + total thickness 187 of the blue organic light-emitting layer 142B [Equation 4]

The height 182 of the undercut structure 1830 can be at least greater than the sum of the thickness 184 of the third anode electrode 141b (or the second anode electrode 141r), the thickness 185 of the first stack ST1, and the thickness 186 of the charge generation layer CGL. The height 182 of the undercut structure 1830 can be smaller than the sum of the thickness 184 of the third anode electrode 141b (or the second anode electrode 141r) and the total thickness 187 of the blue organic emission layer 142B. The total thickness 187 of the blue organic light-emitting layer 142B can be the total thickness of all organic light-emitting layers included in the blue organic light-emitting layer 142B shown in FIG. 9B.

Meanwhile, the depth 183 of the undercut structure 1830 can be more than twice the height 182 of the undercut structure 1830, considering the deviation of the process.

For example, as shown in FIG. 9B, in a structure having a two-stack tandem structure, the height 182 and depth 183 of the undercut structure 1830 can be calculated as follows.

Thickness 184 of the third anode electrode 141b: 50 nanometers

Thickness 185 of first stack ST1: 150 nanometers

Thickness 186 of charge generation layer CGL: 20 nanometers

Total thickness 187 of blue organic light-emitting layer 142B: 450 nanometers

The height 182 of the undercut structure 1830 can be calculated in the range of 220 nanometers to 500 nanometers, and the depth 183 of the undercut structure 1830 can be calculated in the range of 440 nanometers to 1,000 nanometers.

Meanwhile, in a structure having a two-stack tandem structure, the height 182 and depth 183 of the undercut structure 1830 calculated in Equation 4 can be changed depending on the degree of integration. Equation 4 can be equally applied to a structure with a single stack (FIG. 9A).

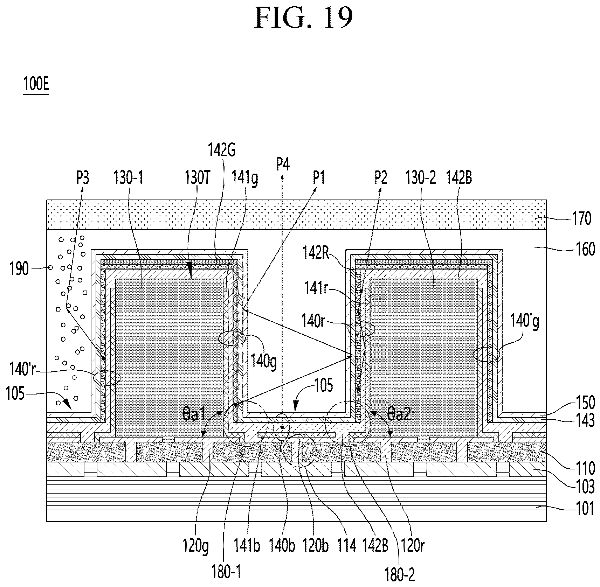

FIG. 19 is a cross-sectional view showing an organic light-emitting display device according to a fifth embodiment.

The example is the same as the third example (FIG. 7) except for the light scattering particle 190. In the fifth embodiment, components having the same structure, shape, and/or function as those of the third embodiment (FIG. 7) are given the same reference numerals and detailed descriptions are omitted. The fifth embodiment can be equally applied to the first, second, and fourth embodiments.

Referring to FIG. 19, the organic light-emitting display device 100E according to the fifth embodiment can comprise a substrate 101, a plurality of driving circuits 103, a protective layer 110, a plurality of auxiliary electrodes 120g, 120r, and 120b, etc. The organic light-emitting display device 100E according to the fifth embodiment can comprise a first three-dimensional structure 130-1, a second three-dimensional structure 130-2, a green organic light-emitting element 140g, a red organic light-emitting element 140r, a blue organic light-emitting element 140b, etc. The organic light-emitting display device 100E according to the fifth embodiment can comprise a first insulating layer 150, a second insulating layer 160, a third insulating layer 170, etc.

The light scattering particles 190 can be included in the second insulating layer 160. In the drawing, the light scattering particles 190 are included only in the second insulating layer 160 on the leftmost separation region 105, but the light scattering particles 190 can also be included in the second insulating layer 160 on other separation regions 105.

A green light emitted from the green organic light-emitting element 140g, a red light emitted from the red organic light-emitting element 140r, and a blue light emitted from the blue organic light-emitting element 140b can proceed to the second insulating layer 160 between the first three-dimensional structure 130-1 and the second three-dimensional structure 130-2.

For example, the first anode electrode 141g, the second anode electrode 141r, and the third anode electrode 141b can comprise a reflective film. For example, the cathode electrode 143 can comprise a semi-permeable membrane. The green light, the red light, and the blue light can be reflected by the reflective film or the semi-transmissive film and emitted forward. Here, P1 to P4 can represent optical paths. Some light, for example, the red light, can be totally reflected upward within the red organic light-emitting element 140r and emitted forward (P2).

Meanwhile, some light, the red light, can be scattered by the light scattering particles 190 and emitted forward (P3). Since more light is extracted to the outside by the light scattering particles 190, light luminance can be increased.

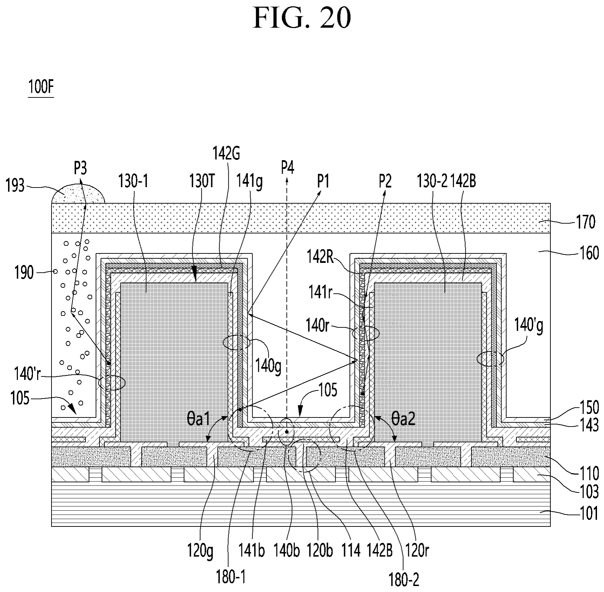

FIG. 20 is a cross-sectional view showing an organic light-emitting display device according to a sixth embodiment.

The embodiment is the same as the fifth embodiment (FIG. 19) except for the lens structure 193. In the sixth embodiment, components having the same structure, shape, and/or function as those of the fifth embodiment (FIG. 19) are given the same reference numerals and detailed descriptions are omitted. The sixth embodiment can be equally applied to the first to fourth embodiments.

Referring to FIG. 20, the organic light-emitting display device 100F according to the sixth embodiment can comprise a substrate 101, a plurality of driving circuits 103, a protective layer 110, a plurality of auxiliary electrodes 120g, 120r, and 120b, etc. The organic light-emitting display device 100F according to the sixth embodiment can comprise a first three-dimensional structure 130-1, a second three-dimensional structure 130-2, a green organic light-emitting element 140g, a red organic light-emitting element 140r, a blue organic light-emitting element 140b, etc. The organic light-emitting display device 100F according to the sixth embodiment can comprise a first insulating layer 150, a second insulating layer 160, a third insulating layer 170, etc.

The lens structure 193 can be disposed on the third insulating layer 170. For example, the lens structure 193 can be disposed on the second insulating layer 160 between the first three-dimensional structure 130-1 and the second three-dimensional structure 130-2.

The structure of lens 193 is shown as convex, but can be concave. After the light passes through the insulating film 170 between the first three-dimensional structure 130-1 and the second three-dimensional structure 130-2, it can be incident on the lens 193, and can then be incident on and emitted from another layer provided on top of the lens 193. Through this process, the lens 193 can be optimized so that the light can be emitted forward as much as possible without being totally reflected on the upper and lower surfaces of the lens 193 and match the refractive index of each of the layers through which the light passes.

Although not shown, light extraction efficiency can be maximized by patterning the second insulating layer 160 into a lens structure to prevent total reflection from occurring at the interface with the third insulating layer 170.

A green light emitted from the green organic light-emitting element 140g, a red light emitted from the red organic light-emitting element 140r, and a blue light emitted from the blue organic light-emitting element 140b can be emitted forward through the second insulating layer 160 between the first three-dimensional structure 130-1 and the second three-dimensional structure 130-2. In this case, the green light, the red light, and the blue light in the second insulating layer 160 can be focused by the lens structure 193. Each lens structure 193 can be larger than or equal to the width of the second insulating layer 160.

When the second insulating layer 160 comprises the light scattering particles 190, the green light, the red light, and the blue light scattered by the light scattering particles 190 can be focused by the lens structure 193, thereby increasing light luminance. The light scattering particle 190 can be omitted.

Although one lens structure 193 is shown in the drawing, a lens structure 193 can be disposed on the upper surface of each second insulating layer 160 between the plurality of first three-dimensional structures 130-1 and the plurality of second three-dimensional structures 130-2. can be disposed.

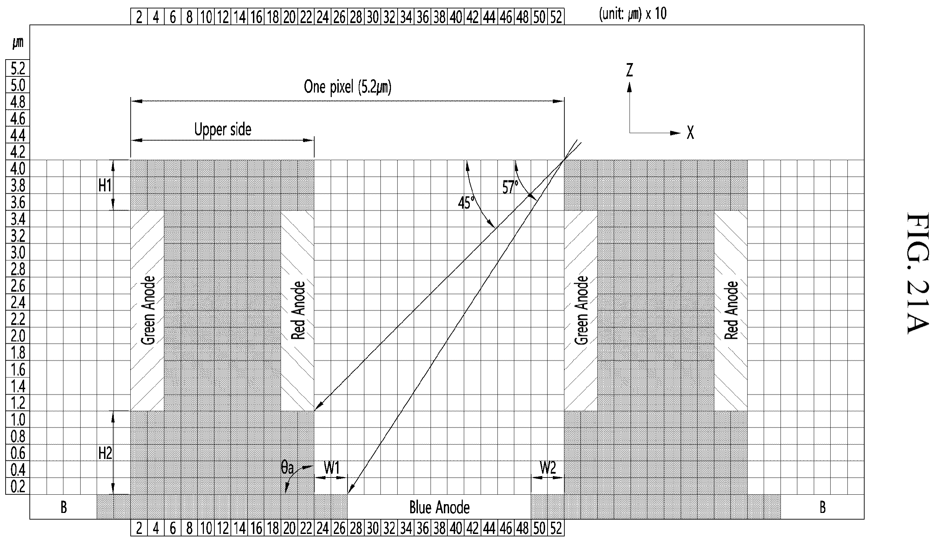

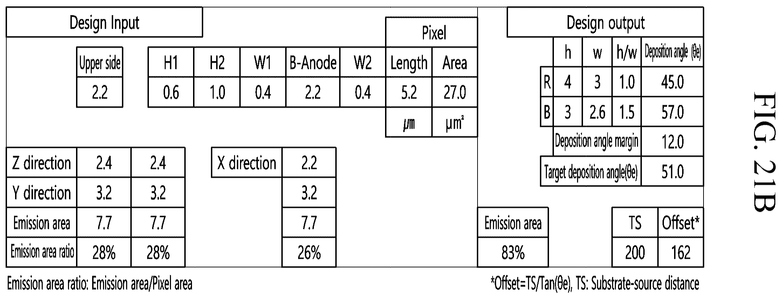

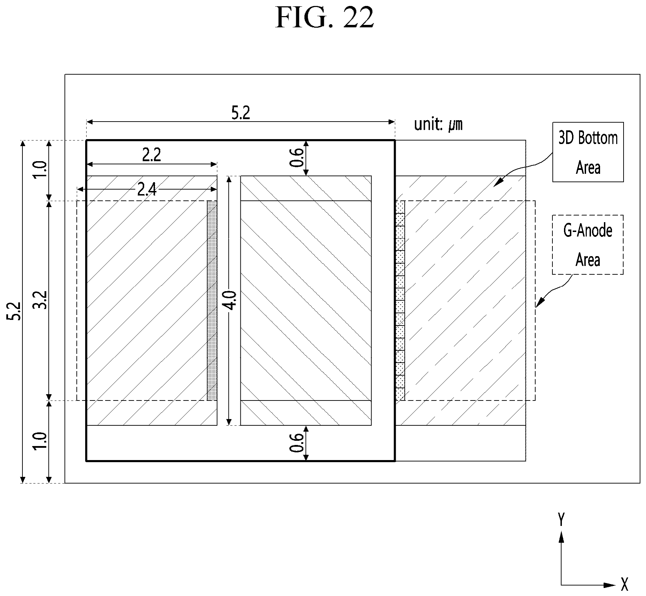

FIG. 21A is a cross-sectional view of a schematic panel design of an AR product. FIG. 21B is a design data sheet for the panel design of FIG. 21A. FIG. 22 is a plan view of a schematic panel design of an AR product.

As described above, the larger the average wall angle θa, the smaller the pixel P (or subpixel) can be, which is advantageous for high resolution. FIGS. 21 and 22 were designed as screens with the highest level of integration physically possible.

Referring to FIGS. 21 and 22, the diagonal size of the screen of the target product can be 0.6", the screen ratio can be 16:9, and the resolution can be QHD (Quad HD).

In this case, the integration of the pixel P of the panel can be 4,900ppi, and the size of the pixel P can be 5.2μm.

Through this design, the theoretical emission area ratio and target deposition angle θe were calculated. The light emission area ratio can be the total area of each color emitted from the subpixel divided by the area of the pixel P. The target deposition angle θe can be an angle at which the desired organic light-emitting material is deposited only on a specific area of the second three-dimensional structure 130-2 and is not deposited on other area, such as separation region 105, etc. by using the shadow effect caused by the first three-dimensional structure 130-1.

As shown in FIG. 22, the height of each of the first three-dimensional structure 130-1 and the second three-dimensional structure 130-2 can be designed to be 4μm. The width in the first direction X of the lower surface of each of the first three-dimensional structure 130-1 and the second three-dimensional structure 130-2 can be designed to be 2.2μm, and the width in the second direction Y can be designed to be 4.0 μm. The distance between rows of three-dimensional structures 130-1 and 130-2 can be designed to be 1.2μm. If the vertical margin of the red and green anode electrodes is designed to be 0.6μm on the upper side and 1.0μm on the lower side, and the spacing between rows is 1.0μm, the total emission area (anode area) can be 22.4 $\mu m^2$. In this case, the emission area ratio, which is the total emission area divided by the pixel P area (27 $\mu m^2$), can be calculated as 83%.

The target deposition angle θe can be 51 degrees, and the deposition angle margin can be ±6 degrees.

Compared to the emission area ratio of 20 to 25% of typical 500 ppi mobile phone products, in the structure of the embodiment, although the integration of pixel P is 5,000 ppi, which is 10 times more, it can be possible to manufacture products with an emission area ratio of 3 times or more. In addition, the SAD structure of the embodiment can implement a side-by-side structure in a product area with an integration density of pixels P where FMM cannot be used, so that it can be seen that this is a groundbreaking technology that can improve the brightness and lifespan of products.

The above detailed description should not be construed as limiting in all respects and should be considered illustrative. The scope of the embodiment should be determined by reasonable interpretation of the appended claims, and all changes within the equivalent range of the embodiment are included in the scope of the embodiment.

## Claims

**1.** An organic light-emitting display device, comprising:

a first three-dimensional structure on a substrate;
a second three-dimensional structure spaced apart from the first three-dimensional structure with a separation region therebetween along a first direction on the substrate;
a first subpixel on one side surface of the first three-dimensional structure;
a second subpixel on one side surface of the second three-dimensional structure; and
a third subpixel on the separation region,
wherein the first subpixel comprises a first organic light-emitting device,
wherein the second subpixel comprises a second organic light-emitting device,
wherein the third subpixel comprises a third organic light-emitting element,
wherein the first three-dimensional structure and the second three-dimensional structure each have a structure that is separated into at least a unit of one or more pixel along a second direction or a long structure as one piece, and
wherein the one side surface of the first three-dimensional structure and the one side surface of the second three-dimensional structure are each perpendicular to the substrate.

2. The organic light-emitting display device of claim 1, wherein the one side surface of the first three-dimensional structure has a first average wall angle with respect to the substrate,

   the one side surface of the second three-dimensional structure has a second average wall angle with respect to the substrate, and
   the first average wall angle and the second average wall angle are the same.

3. The organic light-emitting display device of claim 1, comprising:

   another second subpixel on the other side surface of the first three-dimensional structure; and
   another first subpixel on the other side surface of the second three-dimensional structure.

4. The organic light-emitting display device of claim 1, wherein one or two or more first organic light-emitting devices are provided on the one side surface of the first three-dimensional structure along the second direction,

   one or two or more second organic light-emitting devices are provided on the one side surface of the second three-dimensional structure along the second direction, and
   one or two third organic light-emitting devices are provided on the third auxiliary electrode along the second direction.

5. The organic light-emitting display device of claim 1, further comprising:

   a first anode separation structure along the perimeter of the first three-dimensional structure; and
   a second anode separation structure along the perimeter of the second three-dimensional structure.

6. The organic light-emitting display device of claim 5, wherein the first organic light-emitting device, the second organic light-emitting device, and the third organic light-emitting device comprise a charge generation layer in common,

   the first anode separation structure is configured to disconnect the charge generation layer between the first subpixel and the third subpixel, and
   the second anode separation structure is configured to disconnect the charge generation layer between the second subpixel and the third subpixel.

7. The organic light-emitting display device of claim 1, further comprising:

   a first insulating layer on the first organic light-emitting device, the second organic light-emitting device, and the third organic light-emitting device;
   a second insulating layer on the first insulating layer between the first three-dimensional structure and the second three-dimensional structure; and
   a third insulating layer on the second insulating layer.

8. The organic light-emitting display device of claim 7, wherein the third insulating layer is configured to be in contact with an upper surface of the first three-dimensional structure and an upper surface of the second three-dimensional structure.

9. The organic light-emitting display device of claim 8, wherein the second insulating layer comprises light scattering particles.

10. The organic light-emitting display device of claim 7, further comprising:
    a lens structure on the third insulating layer between the first three-dimensional structure and the second three-dimensional structure.

# FIG. 1

SPg
SPb
SPr
A
A'
100
P
B
B'
101
Y
X

# FIG. 2

A
130r
A'
130g
130T
130-2a
130-2b
130-1a
130-1
105
140'g
130-1b
θa1
θa2
Z
Y
140g
140b
130-2
X
130b

FIG. 3

A
130r
A'
130g
130T
130-2a
130-2b
130-1a
130-1
130-1b
θa1
θa2
140'g
Z
Y
X
140g
140b
105
130-2
130b

FIG. 4

A
130g
130r
A'
130T
130-1
130-1b
130-2a
130-2b
θa1
θa2
Z
Y
X
130-1a
140g
140b
130-2
105
130b
140'g

# FIG. 5

100A
P
SPb
SPr
SPg
SPb
SPr
SPg
SPb
130-1
130T
130-2
170
160
142G
142R
140'r
140g
140r
140'g
141g
105
141r
180-1
180-2
150
θa1
θa2
143
110
103
101
Z
B
B'
120g
141b
140b
120b
114
142B
120r
X

# FIG. 6

100B
P
SPb
SPr
SPg
SPb
SPr
SPg
SPb
130-1
130T
142G
142R
130-2
170
140'r
140g
140r
140'g
160
105
141g
141r
180-1
180-2
θa1
θa2
150
143
110
103
101
Z
B
B'
X
120g
141b
140b
120b
114
142B
120r

# FIG. 7

100C
P
SPb
SPr
SPg
SPb
SPr
SPg
SPb
130-1
130T
130-2
142B
170
160
142G
142R
141g
141r
140'r
140g
140r
140'g
105
180-1
180-2
θa1
θa2
150
143
110
103
101
Z
B
B'
X
120g
141b
140b
120b
114
142B
120r
Area X

# FIG. 8

100D
P
SPb
SPr
SPg
SPb
SPr
SPg
SPb
130-1
130T
142g
142G
142R
142r
130-2
170
160
188
140'r
140g
140r
140'g
105
180-1
180-2
θa1
θa2
150
143
110
103
101
Z
X
B
B'
120g
141b
140b
120b
114
142B
120r

# FIG. 9A

140g
140b
140r
CPL
Cathode
ETL
G-EML
EBL
B-EML
EBL
HTL
CPL
Cathode
ETL
B-EML
EBL
HTL
CPL
Cathode
ETL
R-EML
EBL
B-EML
EBL
HTL
HIL (P-HTL)
Anode
Anode
Anode
141g
141b
141r

# FIG. 9B

140r
140g
140b
CPL
Cathode
ETL2
R-EML2
ST2
EBL2
B-EML2
HTL2
P-CHL
n-CGL
ELT1
R-EML1
ST1
EBL1
B-EML1
HTL1
Anode
G-EML2
G-EML1
HIL (P-HTL)
141g
141b
141r

# FIG. 10A

CH7
CH6
CH5
CH4
CH3
CH2
CH1

# FIG. 10B

101
130-1
130-2
R-EML
G-EML
B-EML
θe
Offset
TS
253
θa1
θa2
252
130-1a
130-1b
130-2a
130-2b
SPb
SPr
SPg
251

# FIG. 10C

130-1
W2
W1
θa1
θe
θa2
130-2
H
130-1b
130-2b
130T
130-1a
130-2a

# FIG. 11

START
step A1
Forming a plurality of driving circuits 103 on a substrate 101
step A2
Patterning a through hole 114 after a formation of a protective layer 110
step A3
Forming a plurality of auxiliary electrodes 120g, 120r, and 120b
step A4
Forming and patterning three-dimensional structures 130-1 and 130-2
step A5
Patterning the plurality of auxiliary electrodes 120g, 120r, and 120b using the three-dimensional structures 130-1 and 130-2
step A6
Forming a plurality of anode separation structures 180-1 and 180-2
step A7
Depositing and patterning anode electrodes 141g, 141r, and 141b
step A8
Depositing organic light-emitting layers 142B, 142R, and 142G
step A9
Forming a cathode electrode 143
step A10
Forming a first insulating layer 150
step A11
Forming a second insulating layer 160
step A12
Forming a third insulating layer 170
END

FIG. 12A

103
101

FIG. 12B

110
103
101
114

FIG. 12C

120g
120b
120r
110
103
101
114

FIG. 12D

130-1
SPg
SPr
130-2
105
SPb
120g
120b
120r
110
103
101
114

FIG. 12E

130-1
SPg
SPr
130-2
105
SPb
110
103
101
120g
120b
114
120r

# FIG. 12F

130-1
SPg
SPr
130-2
180-1
105
SPb
180-2
110
103
101
120g
120b
114
120r

# FIG. 12G

130-1
130-2
141g
141r
180-1
105
180-2
110
103
101
120g
141b
120b
114
120r

# FIG. 12H

130-1
130-2
141g
141r
180-1
105
180-2
110
103
101
120g
141b
120b
114
142B
120r


# FIG. 12I

130-1
142R
130-2
141g
141r
180-1
105
180-2
110
103
101
120g
141b
120b
114
142B
120r

# FIG. 12J

130-1
142G
142R
130-2
141g
141r
180-1
105
180-2
110
103
101
120g
141b
120b
114
142B
120r

# FIG. 12K

130-1
142G
142R
130-2
141g
141r
140g
140r
180-1
105
180-2
143
110
103
101
120g
141b
120b
114
142B
120r

FIG. 12L

130-1
130-2
142G
142R
141g
141r
140g
140r
180-1
105
180-2
150
143
110
103
101
120g
141b
120b
114
142B
120r

FIG. 12M

130-1
130-2
160
142G
142R
141g
141r
140g
140r
180-1
105
180-2
150
143
110
103
101
120g
141b
120b
114
142B
120r

# FIG. 12N

130-1
130-2
170
160
142G
142R
141g
141r
140g
140r
180-1
105
180-2
150
143
110
103
101
120g
141b
120b
114
142B
120r

# FIG. 13

START
Proceed with steps A1 to A10 in FIG. 11
step A11
Forming a second insulating layer 160
step A111
Removing a first insulating layer 150, a cathode electrode 143, and organic light layers 142G, 142B, and 142R on the upper surface 130T
step A12
Forming a third insulating layer 170
END

# FIG. 14A

130-1
130-2
142G
142R
141g
141r
140g
140r
180-1
105
180-2
150
143
110
103
101
120g
141b
120b
114
142B
120r

FIG. 14B

130T
130-1
130-2
142G
142R
141g
141r
160
140g
140r
180-1
105
180-2
150
143
110
103
101
120g
141b
120b
114
142B
120r

FIG. 14C

130T
130-1
130-2
142G
142R
141g
141r
140g
140r
180-1
105
180-2
160
150
143
110
103
101
120g
141b
120b
114
142B
120r

# FIG. 14D

130T
130-1
130-2
170
142G
142R
160
141g
141r
140g
140r
180-1
105
180-2
150
143
110
103
101
120g
141b
120b
114
142B
120r

# FIG. 15

130-2
123b
122b
120r
121b
113
112
110
111
103
101
1830
180-2
1841
1842
1840
1843
143
140r
141r
130-2a
105
141b
140b
P
SPr
SPb
SPg
140g
141g
130-1a
ST1
CGL
ST2
1823
1822
1820
1821
180-1
1810
X영역
130-1
123a
122a
121a
120g

# FIG. 16

Proceed with steps A1 to A3 in FIG. 11
step A4
Patterning three-dimensional structures 130-1, and 130-2
step A5
Patterning auxiliary electrodes 120g, 120b, and 120r using the three-dimensional structures 130-1, and 130-2
step A6
Forming anode separation structures 180-1, and 180-2
step61
Ashing the three-dimensional structures 130-1, and 130-2
step62
Patterning a third protective film 113 and a second protective film 112
step63
Etching the second protective film (112)
step A7
Patterning after forming anode electrodes 141g, 141b, and 141r
step A8
Depositing organic light emitting layers 142g, 142b, and 142r
step A9
Depositing a cathode electrode 143
Proceed with steps A10 to A12 in FIG. 11

# FIG. 17A

130-2
123b
122b
121b
120r
113
112
111
110
103
101

# FIG. 17B

130-2
1212
123b
122b
121b
120r
113
112
110
111
103
101

# FIG. 17C

130-2
1212
123b
122b
120r
121b
113
112
110
111
103
101

# FIG. 17D

130-2
123b
122b
120r
121b
113
112
110
111
103
101
1830

# FIG. 17E

130-2a
SPr
141r
130-2
123b
122b
120r
121b
SPb
105
113
112
110
141b
111
103
101
1841
1830

# FIG. 17F

141r
SPr
130-2
142R
SPb
142B
105
ST1
CGL
ST2
123b
122b
120r
121b
113
112
110
111
141b
103
101
1843
1842
1841
1840
1830
180-2

FIG. 17G

143
141r
SPr
140r
130-2
142R
SPb
140b
142B
105
ST1
CGL
ST2
123b
122b
120r
121b
113
112
110
111
141b
103
101

# FIG. 18

141r
SPr
130-2
142R
SPb
142B
105
187
ST1
CGL
ST2
123b
122b
120r
121b
113
186
183
182
112
110
141b
111
184
103
101
185
1830

# FIG. 19

100E
142G
P4
P3
130-1
130T
141g
P1
P2
130-2
142B
170
160
142R
190
141r
140r
140'g
140g
140'r
105
105
θa1
θa2
150
143
110
103
101
120g
141b
140b
120b
114
142B
120r
180-1
180-2

# FIG. 20

100F
142G
P3
P4
193
130-1
130T
141g
P1
P2
130-2
142B
170
160
142R
190
141r
140r
140'g
140g
140'r
105
105
150
θa1
θa2
143
110
103
101
120g
141b
140b
120b
114
142B
120r
180-1
180-2

# FIG. 21A

(unit: μm) x 10
Z
X
One pixel (5.2μm)
Upper side
57°
45°
Green Anode
Red Anode
Blue Anode
H1
H2
W1
W2
θa
B

# FIG. 21B

**Design Input**

| Upper side |
|---|
| 2.2 |

| H1 | H2 | W1 | B-Anode | W2 | Pixel Length | Pixel Area |
|---|---|---|---|---|---|---|
| 0.6 | 1.0 | 0.4 | 2.2 | 0.4 | 5.2 | 27.0 |
| | | | | | μm | μm² |

| | | |
|---|---|---|
| Z direction | 2.4 | 2.4 |
| Y direction | 3.2 | 3.2 |
| Emission area | 7.7 | 7.7 |
| Emission area ratio | 28% | 28% |

| | |
|---|---|
| X direction | 2.2 |
| | 3.2 |
| | 7.7 |
| | 26% |

Emission area ratio: Emission area/Pixel area

**Design output**

| | h | w | h/w | Deposition angle (θe) |
|---|---|---|---|---|
| R | 4 | 3 | 1.0 | 45.0 |
| B | 3 | 2.6 | 1.5 | 57.0 |
| Deposition angle margin | | | | 12.0 |
| Target deposition angle(θe) | | | | 51.0 |

| Emission area |
|---|
| 83% |

| TS | Offset* |
|---|---|
| 200 | 162 |

*Offset=TS/Tan(θe), TS: Substrate-source distance

FIG. 22

5.2
unit: μm
3D Bottom Area
G-Anode Area
2.2
2.4
0.6
4.0
0.6
1.0
3.2
1.0
5.2
Y
X